# EUROPEAN PATENT APPLICATION

(11) **EP 4 525 030 A1**
(43) Date of publication of application: **19.03.2025**
(21) Application number: 24191298.9
(22) Date of filing: 26.07.2024
(51) Int. Cl.: H01L 21/768, H01L 23/528, H01L 23/00, H01L 23/532

(54) **SEMICONDUCTOR DEVICES**

(30) Priority: 18.09.2023 KR 20230123604
(71) Applicant: SAMSUNG ELECTRONICS CO., LTD., Yeongtong-gu Suwon-si, Gyeonggi-do 16677 (KR)
(72) Inventor: KWON, Dong Hoon, 16677 Suwon-si (KR)
(74) Representative: Marks & Clerk LLP

(57) **Abstract**

A semiconductor device may include a first substrate, a lower pattern on a first side of the first substrate, a plurality of sheet patterns on the lower pattern and spaced apart from each other in a first direction, a gate electrode which surrounds portions the plurality of sheet patterns, a source/drain pattern which is on one side of the gate electrode and connected to the plurality of sheet patterns, a power rail which is on a second side of the first substrate, a via pattern which extends through the first substrate in the first direction, and is connected to both the power rail and the source/drain pattern, a first dummy pattern on the via pattern, a second substrate on the first dummy pattern, and a second dummy pattern on a third side of the second substrate that faces the first side of the first substrate.

## Description

### BACKGROUND

### 1. Field of the Disclosure

The present disclosure relates to semiconductor devices.

### 2. Description of the Related Art

Scaling technologies have been proposed for increasing density of semiconductor devices. One scaling technology that has been proposed is a multi gate transistor in which a multi-channel active pattern (or a silicon body) having a fin or nanowire shape is formed on a substrate, and a gate is formed on a surface of the multi-channel active pattern.

Since such a multi gate transistor utilizes a three-dimensional channel, scaling may be performed relatively easily. Further, even if a gate length of the multi gate transistor is not increased, the current control capability may be improved. Furthermore, a SCE (short channel effect) in which potential of a channel region is influenced by a drain voltage may be suppressed or reduced in a relatively effective manner.

### SUMMARY

Aspects of the present disclosure provide semiconductor devices having improved reliability.

However, aspects of the present disclosure are not restricted to the ones set forth herein. The above and other aspects of the present disclosure will become more apparent to those of ordinary skill in the art to which the present disclosure pertains by referencing the detailed description of the present disclosure given below.

According to some aspects of the present disclosure, there is provided a semiconductor device comprising a first substrate which includes a first side and a second side that are opposite to each other in a first direction, a lower pattern on the first side of the first substrate, the lower pattern extending in a second direction that intersects the first direction, a plurality of sheet patterns which are spaced apart from each other in the first direction on the lower pattern, a gate electrode surrounding portions of the plurality of sheet patterns on the first side of the first substrate and extending in a third direction, a source/drain pattern which is on one side of the gate electrode and connected to the plurality of sheet patterns, a power rail which is on the second side of the first substrate and which extends in the second direction, a via pattern which extends through the first substrate in the first direction, the via pattern connected to each of the power rail and the source/drain pattern, a first dummy pattern that includes an insulating material on the via pattern, a second substrate which includes, on the first dummy pattern, a third side that faces the first side, and a fourth side opposite to the third side in the first direction, and a second dummy pattern on the third side of the second substrate, the second pattern including an insulating material, wherein the first dummy pattern and the second dummy pattern overlap each other in the first direction.

According to some aspects of the present disclosure, there is provided a semiconductor device comprising a first substrate which includes a first side and a second side that are opposite to each other in a first direction, a lower pattern on the first side of the first substrate, the lower pattern extending in a second direction that intersects the first direction, a field insulating film on a first side of the first substrate and on a side wall of the lower pattern, a plurality of sheet patterns which are spaced apart from each other in the first direction on the lower pattern, a gate electrode surrounding portions of the plurality of sheet patterns on the first side of the first substrate, the gate electrode extending in a third direction, a source/drain pattern which is on one side of the gate electrode and connected to the plurality of sheet patterns, a power rail on the second side of the first substrate and extends in the second direction, a via pattern which extends through the first substrate and the field insulating film in the first direction, and is connected to each of the power rail and the source/drain pattern, a first insulating film on the first side of the first substrate, a first dummy pattern arranged in the first insulating film, the first dummy pattern include an insulating material that is a different material than a material included in the first insulating film, a second substrate which includes, on the first dummy pattern, a third side that faces the first side, and a fourth side opposite to the third side in the first direction, a second insulating film on the third side of the second substrate, and a second dummy pattern in the second insulating film and including an insulating material that is different from a material included in the second insulating film, wherein the first dummy pattern and the second dummy pattern are offset in the first direction.

According to some aspects of the present disclosure, there is provided a semiconductor device comprising a first substrate which includes a first side and a second side opposite to each other in a first direction, a plurality of lower patterns which extend in a second direction on the first side of the first substrate, and are spaced apart from each other in a third direction, a field insulating film on side walls of the plurality of lower patterns, on the first side of the first substrate, a plurality of sheet patterns which are spaced apart from each other in the first direction, on the plurality of lower patterns, a plurality of gate electrodes which surround portions of the plurality of sheet patterns on the first side of the first substrate, extend in the third direction, and are spaced apart from each other in the second direction, a plurality of source/drain patterns which are between the plurality of gate electrodes, each of the plurality of source/drain patterns connected to at least one of the plurality of sheet patterns, a plurality of source/drain contacts which are on each of the plurality of source/drain patterns, a power rail which is on the second side of the first substrate and extends in the second direction, a plurality of via patterns which extend through the first substrate and the field insulating film in the first direction, and are connected to each of the power rail and the plurality of source/drain patterns, a first insulating film on the first side of the first substrate, a first dummy pattern which extends through the first insulating film, and includes an insulating material that is different from a material included the first insulating film, a first adhesive film which covers the first insulating film and the first dummy pattern, a second substrate which includes, on the first dummy pattern, a third side that faces the first side, and a fourth side opposite to the third side in the first direction, a second insulating film on the third side of the second substrate, a second dummy pattern which extends through the second insulating film, and includes an insulating material that is a different material from a material included the second insulating film, and a second adhesive film which covers the second insulating film and the second dummy pattern, wherein the first adhesive film is bonded to the second adhesive film, wherein each of the first dummy pattern and the second dummy pattern has at least one of a circular shape, a quadrangular shape, and a bar shape when viewed in a plan view, wherein the first dummy pattern and the second dummy pattern overlap each other in the first direction, wherein the first insulating film and the second insulating film include the same material, and wherein the first dummy pattern and the second dummy pattern include the same material.

At least some of the above and other features of the disclosure are set out in the claims.

### BRIEF DESCRIPTION OF THE DRAWINGS

The above and other aspects and features of the present disclosure will become more apparent by describing in detail embodiments thereof with reference to the attached drawings, in which:
FIG. 1 is a layout diagram for explaining a semiconductor device according to some embodiments.
FIG. 2 is a cross-sectional view taken along line A-A' of FIG. 1.
FIG. 3 is a cross-sectional view taken along line B-B' of FIG. 1.
FIGS. 4 to 23 are diagrams for explaining a semiconductor device according to some embodiments.
FIGS. 24 to 35 are intermediate diagrams for explaining a method for fabricating a semiconductor device according to some embodiments of the present disclosure.

### DETAILED DESCRIPTION OF THE EMBODIMENTS

Although terms such as first and second are used to describe various elements or components in the present specification, those of ordinary skill in the art will readily understand that these elements or components are not limited by these terms. These terms are only used to distinguish a single element or component from other elements or components. Therefore, an element or component referred to below as a first element or component may be a second element or component within the technical idea of the present disclosure. Additionally, terms such as on, above, or below are used to describe orientation of various elements or components in the present specification, those of ordinary skill in the art will readily understand that these elements or components are not limited to the particular directions described, but rather it is relative orientations of elements or components which is described. For example, references to an element being on another element may mean it is above or below the other element in a particular direction. Further, references to on may not necessarily indicate an element or component is directly on another element or component, rather it is intended to include the element or component being directly or indirectly on the other element or component.

Although drawings of the semiconductor device according to some embodiments show a transistor including a nanowire or a nanosheet, and a MBCFET^{™} (Multi-Bridge Channel Field Effect Transistor) as an example, the inventive concepts of the present disclosure are not limited thereto. The semiconductor device according to some embodiments may include a tunneling transistor (tunneling FET) or a three-dimensional (3D) transistor. The semiconductor device according to some embodiments may include a planar transistor. In addition, the inventive concepts of the present disclosure may be applied to a transistor based on two-dimensional material (2D material based FETs) and a heterostructure thereof.

Further, the semiconductor device according to some embodiments may also include a bipolar junction transistor (BJT), a laterally diffused metal oxide semiconductor (LDMOS), or the like.

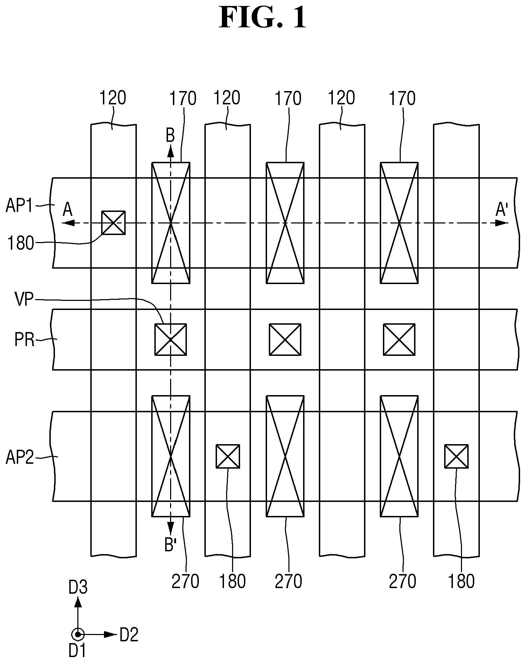

Some embodiments according to the inventive concepts of the present disclosure will be described below with reference to the accompanying drawings. First, a semiconductor device according to some embodiments of the present disclosure will be described with reference to FIGS. 1 to 3.

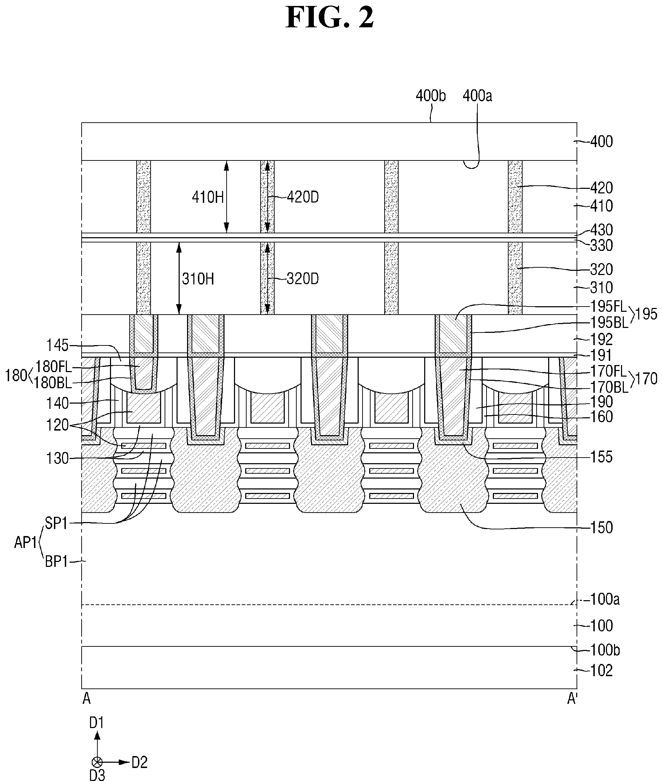

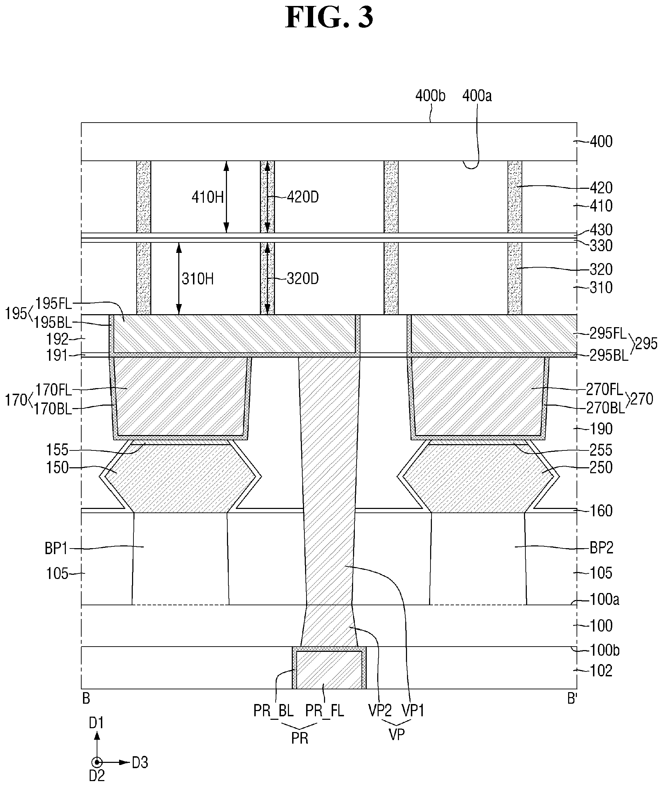

FIG. 1 is a layout diagram for explaining a semiconductor device according to some embodiments. FIG. 2 is a cross-sectional view taken along line A-A' of FIG. 1. FIG. 3 is a cross-sectional view taken along line B-B' of FIG. 1.

Referring to FIGS. 1 to 3, a semiconductor device according to some embodiments may include a first active pattern AP1, a second active pattern AP2, a plurality of gate electrodes 120, a first source/drain contact 170, a second source/drain contact 270, a gate contact 180, a power rail PR, a via pattern VP, a first dummy pattern 320, and a second dummy pattern 420.

First, a first substrate 100 may be provided. The first substrate 100 may include a first side 100a and a second side 100b that are opposite to each other in a first direction D1. The first side 100a of the first substrate 100 may be referred to as an upper side of the first substrate 100 or a front side of the first substrate 100. The second side 100b of the first substrate 100 may be referred to as a lower side of the first substrate 100 or a back side of the first substrate 100.

The first substrate 100 may be bulk silicon or silicon-on-insulator (SOI). In some embodiments, the first substrate 100 may be a silicon substrate, or may include other materials, for example, silicon germanium, SGOI (silicon germanium on insulator), indium antimonide, lead telluride, indium arsenide, indium phosphide, gallium arsenide or gallium antimonide, as examples.

The first active pattern AP1 and the second active pattern AP2 may each be on the first side 100a of the first substrate 100. The first active pattern AP1 and the second active pattern AP2 may each extend in length on the first substrate 100 in a second direction D2, such that a greatest dimension of each of the first active pattern and the second active pattern is in the second direction D2. The first active pattern AP1 and the second active pattern AP2 may be spaced apart from each other in a third direction D3.

When viewed in a plan view, the first active pattern AP1 and the second active pattern AP2 may each include a relatively long side extending in the second direction D2 and a relatively short side extending in the third direction D3. Here, the second direction D2 may intersect the third direction D3 and the first direction D1. Further, the third direction D3 may intersect the first direction D1. The first direction D1 may be a thickness direction of the first substrate 100. The first direction may be perpendicular to the first side 100a of the first substrate 100.

Each of the first active pattern AP1 and the second active pattern AP2 may be a multi-channel active pattern. The first active pattern AP1 may include a first lower pattern BP1 and a plurality of first sheet patterns SP1. The second active pattern AP2 may include a second lower pattern BP2 and a plurality of second sheet patterns.

The first lower pattern BP1 may protrude from the first substrate 100 in the first direction D 1. The first lower pattern BP1 may extend in length in the second direction D2. The first lower pattern BP1 may be a fin-shaped pattern. A plurality of first sheet patterns SP1 may be on the first lower pattern BP1. The plurality of first sheet patterns SP1 may be spaced apart from the first lower pattern BP1 in the first direction D1. Furthermore, the plurality of first sheet patterns SP1 may be spaced apart from each other in the first direction D1. Although three first sheet patterns SP1 are shown as being arranged above the first lower pattern BP1 in the first direction D1, this is only for convenience of explanation, and the present disclosure is not limited thereto.

The second lower pattern BP2 may protrude from the first substrate 100 in the first direction D1. The second lower pattern BP2 may extend in length in the second direction D2. The second lower pattern BP2 may be a fin-shaped pattern. Although not shown, a plurality of second sheet patterns may be on the second lower pattern BP2. The plurality of second sheet patterns may be spaced apart from the second lower pattern BP2 in the first direction D1. Furthermore, the plurality of second sheet patterns may be spaced apart from each other in the first direction D1. The number of second sheet patterns on the second lower pattern BP2 may be equal to the number of first sheet patterns SP1 on the first lower pattern BP1, although the present disclosure is not limited thereto.

The first lower pattern BP1 and the second lower pattern BP2 may each be formed by etching a part of the first substrate 100, and may include an epitaxial layer grown from the first substrate 100. The first lower pattern BP1 and the second lower pattern BP2 may each include silicon or germanium, which are elemental semiconductor materials. Further, the first lower pattern BP1 and the second lower pattern BP2 may each include a compound semiconductor, and may include, for example, a group IV-IV compound semiconductor or a group III-V compound semiconductor.

The group IV-IV compound semiconductor may be, for example, a binary compound or a ternary compound including at least two or more of carbon (C), silicon (Si), germanium (Ge), and tin (Sn), or a compound obtained by doping these elements with a group IV element.

The group III-V compound semiconductor may be, for example, one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element.

The first sheet patterns SP1 and the second sheet patterns may each include one of silicon or germanium which are elemental semiconductor materials, a group IV-IV compound semiconductor or a group III-V compound semiconductor. Each first sheet pattern SP1 may include the same material as the first lower pattern BP1, and may include a different material from the first lower pattern BP1. Each second sheet pattern may include the same material as the second lower pattern BP2, and may include a different material from the second lower pattern BP2.

In the semiconductor device according to some embodiments, the first lower pattern BP1 and the second lower pattern BP2 may each be a silicon lower pattern including silicon, and the first sheet patterns SP1 and the second sheet patterns may each be a silicon sheet pattern including silicon.

A field insulating film 105 may be on the first substrate 100. The field insulating film 105 may be on the first side 100a of the first substrate 100.

The field insulating film 105 may cover the side walls of the first lower pattern BP1 and the side walls of the second lower pattern BP2. Each first sheet pattern SP1 and each second sheet pattern may be arranged higher than an upper side or upper surface of the field insulating film 105. The field insulating film 105 may include, for example, an oxide film, a nitride film, an oxynitride film or a combination thereof. Although the field insulating film 105 is shown as being a single film, the present disclosure is not limited thereto. In some embodiments, and in contrast to the shown example, the field insulating film 105 may include a field liner which extends along the side walls and a bottom side of a fin trench that defines the first and second lower patterns BP1 and BP2, and the field insulating film 105 may include a field filling film on the field liner.

A plurality of gate electrodes 120 may be on the first substrate 100. For example, the plurality of gate electrodes 120 may be on the field insulating film 105. Each of the plurality of gate electrodes 120 may extend in length in the third direction D3. The plurality of gate electrodes 120 may be spaced apart from each other in the second direction D2.

The plurality of gate electrodes 120 may be on the first active pattern AP1 and the second active pattern AP2. The plurality of gate electrodes 120 may intersect the first active pattern AP1 and the second active pattern AP2. The plurality of gate electrodes 120 may wrap or surround portions of the first sheet pattern SP1 and the second sheet pattern. Each of the plurality of gate electrodes 120 may include a relatively long side extending in the third direction D3, and a relatively short side extending in the second direction D2.

As seen in FIG. 2, an upper side or upper surface of each of the plurality of gate electrodes 120 may be, but are not limited to, a convex curved face or a concave curved face recessed toward the upper side of the first lower pattern BP1. In some embodiments and in contrast to the shown example, the upper sides or upper surfaces of each of the plurality of gate electrodes 120 may be a flat plane.

Each of the plurality of gate electrodes 120 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), or vanadium (V), or a combination of two or more thereof.

The plurality of gate electrodes 120 may each include a conductive metal oxide, conductive metal oxynitride, or the like, and may include an oxidized form of the aforementioned materials.

The plurality of gate electrodes 120 may be on both sides of a first source/drain pattern 150, which will be described below. Although not shown, the plurality of gate electrodes 120 may be on both sides of the second source/drain pattern 250.

In some embodiments, both of the gate electrodes 120 on first and second opposite sides of the first source/drain pattern 150 or on first and second opposite sides of the second source/drain pattern 250 may be normal gate electrodes that are used as gates of transistors. As another example, a first gate electrode 120 on a first side of the source/drain pattern 150 or on a first side of the second source/drain pattern 250 may be used as a gate of a transistor, but a second gate electrode 120 on a second side of the first source/drain pattern 150 or a second side of the second source/drain pattern 250 may be a dummy gate electrode.

A plurality of gate spacers 140 may be on the side walls of each of the plurality of gate electrodes 120. The plurality of gate spacers 140 may not come into contact with the plurality of gate electrodes 120, or stated differently the plurality of gate spacers 140 may be free from contact with the plurality of gate electrodes 120. A gate insulating film 130 may be between the gate spacer 140 and the side walls of the gate electrode 120. Each of the plurality of gate spacers 140 may extend in length in the third direction D3. The plurality of gate spacers 140 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), or silicon oxycarbide (SiOC), or a combination of two or more thereof.

The gate insulating film 130 may extend between the gate electrodes 120 and the upper side of the field insulating film 105, between the gate electrodes 120 and the upper side of the first lower pattern BP1, between the gate electrodes 120 and the upper side of the second lower pattern BP2, between the gate electrodes 120 and the first sheet patterns SP1, and between the gate electrodes 120 and the second sheet patterns. The gate insulating film 130 may be between the gate electrodes 120 and the gate spacers 140. Further, the gate insulating film 130 may be formed between the first source/drain pattern 150 and the gate electrodes 120.

The gate insulating film 130 may include silicon oxide, silicon oxynitride, silicon nitride, or a high dielectric constant material having a higher dielectric constant than silicon oxide. The high dielectric constant material may include, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

Although the gate insulating film 130 is shown as a single film, this example is only for convenience of explanation and the present disclosure is not limited thereto. The gate insulating film 130 may include a plurality of films.

A semiconductor device according to some embodiments may include an NC (Negative Capacitance) FET that uses a negative capacitor. For example, the gate insulating film 130 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. In some embodiments, because of the increased overall capacitance value, a transistor including the ferroelectric material film may have a subthreshold swing (SS) below 60 mV/decade at room temperature, e.g., 20 degrees Centigrade.

The ferroelectric material film may have ferroelectric properties. The ferroelectric material film may include, for example, at least one of hafnium oxide, hafnium zirconium oxide, barium strontium titanium oxide, barium titanium oxide, and/or lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and/or tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have paraelectric properties. The paraelectric material film may include at least one of, for example, a silicon oxide and a metal oxide having a high dielectric constant. The metal oxide included in the paraelectric material film may include, for example, but is not limited to, at least one of hafnium oxide, zirconium oxide, and/or aluminum oxide.

The ferroelectric material film and the paraelectric material film may include the same material. The ferroelectric material film may have the ferroelectric properties, but the paraelectric material film may not have the ferroelectric properties. For example, when the ferroelectric material film and the paraelectric material film include hafnium oxide, a crystal structure of hafnium oxide included in the ferroelectric material film may be different from a crystal structure of hafnium oxide included in the paraelectric material film.

The ferroelectric material film may have a thickness having ferroelectric properties. A thickness of the ferroelectric material film may be, for example, but is not limited to, 0.5 to 10 nm. Since a critical thickness that exhibits the ferroelectric properties may vary for each ferroelectric material, the thickness of the ferroelectric material film may vary depending on the ferroelectric material.

As an example, the gate insulating film 130 may include one ferroelectric material film. As another example, the gate insulating film 130 may include a plurality of ferroelectric material films spaced apart from each other. The gate insulating film 130 may have a stacked film structure in which the plurality of ferroelectric material films and the plurality of paraelectric material films are alternately stacked.

A plurality of gate capping films 145 may be on the upper sides of the plurality of gate electrodes 120 and the plurality of gate spacers 140. The plurality of gate capping films 145 may include, for example, at least one of silicon nitride (SiN), silicon oxynitride (SiON), silicon oxide (SiO₂), silicon carbonitride (SiCN), or silicon oxycarbonitride (SiOCN), or a combination of two or more thereof.

The first source/drain pattern 150 may be on the first substrate 100. The first source/drain pattern 150 may be on the first lower pattern BP1. The first source/drain pattern 150 may be connected to the first lower pattern BP1. A bottom side of the first source/drain pattern 150 may be in contact (e.g., direct contact) with the first lower pattern BP1. The first source/drain pattern 150 may be connected to a plurality of first sheet patterns SP1. A side wall of the first source/drain pattern 150 may be in contact (e.g., direct contact) with the plurality of first sheet patterns SP1.

A pair of first source/drain patterns 150 may be on first and second opposite side faces of the plurality of gate electrodes 120. Each first source/drain pattern 150 may be between a corresponding pair of gate electrodes 120 of the plurality of gate electrodes 120.

For example, the first source/drain patterns 150 may be on first and second sides of the plurality of gate electrodes 120 for example in the second direction D2. In some embodiments, and in contrast to the shown example, a first source/drain pattern 150 may be on a first side of the plurality of gate electrodes 120 and a first source/drain pattern 150 may be absent from a second side of the plurality of gate electrodes 120 opposite from the first side.

Each first source/drain pattern 150 may include an epitaxial pattern. Each first source/drain pattern 150 may include a semiconductor material. Each first source/drain pattern 150 may be included in the source/drain of a transistor that uses the first sheet pattern SP1 as a channel region.

Each first source/drain pattern 150 may be connected to a channel region of the first active pattern AP1 that is used as a channel. For example, each first source/drain pattern 150 may be connected to at least one first sheet pattern SP1.

In some embodiments, the side walls of the first source/drain pattern 150 may have a wavy shape or undulating shape. For example, the side wall of the first source/drain pattern 150 may be concave toward the first sheet pattern SP1. The side walls of the first source/drain pattern 150 may be convex toward the gate electrode 120. However, the technical idea of the present disclosure is not limited thereto. In some embodiments, the side wall of the first source/drain pattern 150 may also or instead be convex toward the first sheet pattern SP1.

The second source/drain pattern 250 may be on the first substrate 100. The second source/drain pattern 250 may be on the second lower pattern BP2. The second source/drain pattern 250 may be connected to the second lower pattern BP2. A bottom side of the second source/drain pattern 250 may be in contact (e.g., direct contact) with the second lower pattern BP2. The second source/drain pattern 250 may be connected to a plurality of second sheet patterns. A side wall of the second source/drain pattern 250 may be in contact (e.g., direct contact) with a plurality of second sheet patterns.

The second source/drain pattern 250 may be on first and second opposite side faces of the plurality of gate electrodes 120. Each second source/drain pattern 250 may be between a corresponding pair of the plurality of gate electrodes 120.

In some embodiments, the second source/drain patterns 250 may be on first and second opposite sides of the plurality of gate electrodes 120 for example in the second direction D2. In some embodiments, and in contrast to the shown example, the second source/drain pattern 250 may be on a first side of the plurality of gate electrodes 120, and may not absent from a second side of the plurality of gate electrodes 120 opposite from the first side.

Each second source/drain pattern 250 may include an epitaxial pattern. Each second source/drain pattern 250 may include a semiconductor material. Each second source/drain pattern 250 may be included in the source/drain of a transistor that uses the second active pattern AP2 as a channel region.

Each second source/drain pattern 250 may be connected to a channel region of the second active pattern AP2 that is used as a channel. For example, the second source/drain pattern 250 may be connected to at least one second sheet pattern.

An etching stop film 160 may extend along profiles or surfaces of the upper side of the field insulating film 105, the side walls of the plurality of gate spacers 140, the first source/drain pattern 150, and the second source/drain pattern 250. The etching stop film 160 may be on the upper side of the first source/drain pattern 150, the side walls of the first source/drain pattern 150, the upper side of the second source/drain pattern 250, the side walls of the second source/drain pattern 250, and the side walls of the plurality of gate spacers 140. In some embodiments, the etching stop film 160 is not on the side walls of the gate capping film 145. That is, the gate capping film 145 may be on or above the upper side of the etching stop film 160. Also, the side wall of the etching stop film 160 may be connected to an outer wall of the gate capping film 145, and a side wall of the etching stop film 160 may be aligned with the outer wall of the gate capping film 145 in the first direction D1. In some embodiments, and in contrast to the shown example, the etching stop film 160 may be on the side walls of the gate capping film 145.

The etching stop film 160 may include a material having an etching selectivity with respect to a first interlayer insulating film 190, which will be described below. The etching stop film 160 may include a nitride-based insulating material. For example, it may include at least one of silicon nitride (SiN), silicon oxynitride (SiON), oxycarbonitride (SiOCN), silicon boronitride (SiBN), or silicon oxyboronitride (SiOBN), or a combination of two or more thereof.

The first interlayer insulating film 190 is on the etching stop film 160. The first interlayer insulating film 190 may be on the field insulating film 105. The first interlayer insulating film 190 may be on the first source/drain pattern 150 and the second source/drain pattern 250. The first interlayer insulating film 190 may not cover the upper side of the gate capping film 145. For example, an upper side or upper surface of the first interlayer insulating film 190 may be coplanar with the upper side or upper surface of the gate capping film 145.

The first interlayer insulating film 190 may include, for example, at least one of silicon oxide, silicon nitride, silicon oxynitride, and/or a low dielectric constant material. The low dielectric constant material may include, for example, but is not limited to, at least one of Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, or mesoporous silica, or a combination of two or more thereof.

The first source/drain contact 170 may be on the first source/drain pattern 150 on the first active pattern AP1. The second source/drain contact 270 may be on the second source/drain pattern 250 on the second active pattern AP2. The first source/drain contact 170 may be connected to the first source/drain pattern 150. The second source/drain contact 270 may be connected to the second source/drain pattern 250.

Each gate contact 180 may be connected to at least one of the plurality of gate electrodes 120. Each gate contact 180 may be placed at a position that overlaps at least one of the plurality of gate electrodes 120.

The first source/drain contact 170 may penetrate or extend through the etching stop film 160 and may be connected to the first source/drain pattern 150.

The first source/drain contact 170 may be in the first interlayer insulating film 190. The first source/drain contact 170 may be surrounded by the first interlayer insulating film 190.

A first contact silicide film 155 may be between the first source/drain contact 170 and the first source/drain pattern 150. Although the first contact silicide film 155 is shown as being provided along a profile of an interface between the first source/drain pattern 150 and the first source/drain contact 170, the present disclosure is not limited thereto. The first contact silicide film 155 may include, for example, a metal silicide material.

The first interlayer insulating film 190 may not cover the upper side of the first source/drain contact 170. In some embodiments, the upper side of the first source/drain contact 170 may not protrude or extend above the upper side of the gate capping film 145. The upper side of the first source/drain contact 170 may be coplanar with the upper side of the gate capping film 145. In some embodiments, and in contrast to the shown example, the upper side of the first source/drain contact 170 may protrude or extend above the upper side of the gate capping film 145.

In some embodiments, the upper side or upper surface of the first source/drain contact 170 may be coplanar with the upper side or upper surface of the gate contact 180. The upper side or upper surface of the first source/drain contact 170 may be coplanar with the upper side or upper surface of the via pattern VP.

In some embodiments, the first source/drain contact 170 may include a first source/drain barrier film 170BL, and a first source/drain filling film 170FL on the first source/drain barrier film 170BL.

Although the bottom side of the first source/drain contact 170 is shown to have a flat shape, the present disclosure is not limited thereto. In some embodiments, the bottom side of the first source/drain contact 170 may have a wavy shape or an undulating shape, in contrast to the shown example.

The first source/drain barrier film 170BL may include, for example, at least one of tantalum (Ta), tantalum nitride (TaN), titanium (Ti), titanium nitride (TiN), titanium silicon nitride (TiSiN), ruthenium (Ru), cobalt (Co), nickel (Ni), nickel boron (NiB), tungsten (W), tungsten nitride (WN), tungsten carbonitride (WCN), zirconium (Zr), zirconium nitride (ZrN), vanadium (V), vanadium nitride (VN), niobium (Nb), niobium nitride (NbN), platinum (Pt), iridium (Ir), rhodium (Rh), and/or a two-dimensional (2D) material. In the semiconductor device according to some embodiments, the two-dimensional material may be a metallic material and/or a semiconductor material. The 2D material may include a 2D allotrope or a 2D compound, and may include, but is not limited to, at least one of graphene, molybdenum disulfide (MoS₂), molybdenum diselenide (MoSe₂), tungsten diselenide (WSe₂), and tungsten disulfide (WS₂). That is, since the above-mentioned 2D materials are only listed by way of example, the 2D materials that may be included in the semiconductor device of the present disclosure are not limited by the above-mentioned materials.

The first source/drain contact filling film 170FL may include, for example, at least one of aluminum (Al), tungsten (W), cobalt (Co), ruthenium (Ru), silver (Ag), gold (Au), manganese (Mn), and/or molybdenum (Mo).

Although the first source/drain contact 170 is shown to include a plurality of conductive films, the present disclosure is not limited thereto. In some embodiments, the first source/drain contact 170 may be a single film, in contrast to the shown example.

A second source/drain contact 270 may penetrate or extend through the etching stop film 160, and may be connected to the second source/drain pattern 250. The second source/drain contact 270 may be on the second source/drain pattern 250.

The second source/drain contact 270 may be in the first interlayer insulating film 190. The second source/drain contact 270 may be surrounded by the first interlayer insulating film 190.

A second contact silicide film 255 may be between the second source/drain contact 270 and the second source/drain pattern 250. Although the second contact silicide film 255 is shown as being formed along a profile of an interface between the second source/drain pattern 250 and the second source/drain contact 270, the present disclosure is not limited thereto. The second contact silicide film 255 may include, for example, a metal silicide material.

The first interlayer insulating film 190 may not cover the upper side of the second source/drain contact 270, and the upper side or upper surface of the second source/drain contact 270 may be free from contact with the first interlayer insulating film 190. For example, the upper side of the second source/drain contact 270 may not protrude or extend above the upper side of the gate capping film 145. The upper side of the second source/drain contact 270 may be coplanar with the upper side of the gate capping film 145. In some embodiments, and in contrast to the shown example, the upper side of the second source/drain contact 270 may protrude above the upper side of the gate capping film 145.

In some embodiments, the upper side of the second source/drain contact 270 may be coplanar with the upper side of the gate contact 180. The upper side of the second source/drain contact 270 may be coplanar with the upper side of the via pattern VP.

In some embodiments, the second source/drain contact 270 may include a second source/drain barrier film 270BL, and a second source/drain filling film 270FL on the second source/drain barrier film 270BL.

Although the bottom side of the second source/drain contact 270 is shown to have a flat shape, the present disclosure is not limited thereto. In some embodiments, the bottom side of the second source/drain contact 270 may have a wavy shape or undulating shape, in contrast to the shown example.

The material included in the second source/drain barrier film 270BL may be the same as the material included in the first source/drain barrier film 170BL. The material included in the second source/drain filling film 270FL may be the same as the material included in the first source/drain filling film 170FL.

Although the second source/drain contact 270 is shown to include a plurality of conductive films, the present disclosure is not limited thereto. In some embodiments, the second source/drain contact 270 may be a single film, in contrast to the shown example.

The gate contact 180 may be on the gate electrode 120. The gate contact 180 may penetrate or extend through the gate capping film 145, and the gate contact 180 may be connected to the gate electrode 120.

In some embodiments, the upper side of the gate contact 180 may be coplanar with the upper side of the gate capping film 145 for example in the second direction D2. In some embodiments, the upper side of the gate contact 180 may protrude above the upper side of the gate capping film 145.

The gate contact 180 may include a gate barrier film 180BL, and a gate filling film 180FL on the gate barrier film 180BL. The materials included in the gate barrier film 180BL and the gate filling film 180FL may be the same as the first source/drain barrier film 170BL and the first source/drain filling film 170FL, respectively, and description of the materials of the gate barrier film 180BL and the gate filling film 180FL is omitted here in favor of the previous description of the materials of the first source/drain barrier film 170BL and the first source/drain filling film 170FL.

Although the gate contact 180 is shown to include a plurality of conductive films, the present disclosure is not limited thereto. In some embodiments, the gate contact 180 may be a single layer, in contrast to the shown example.

The semiconductor device according to some embodiments may include a lower insulating film 102. The lower insulating film 102 may be on the second side 100b of the first substrate 100. The lower insulating film 102 may be in contact with the second side 100b of the first substrate 100.

The lower insulating film 102 may include, for example, at least one of silicon oxide, silicon nitride, silicon oxynitride, and/or a low dielectric constant material. The low dielectric constant material may include, for example, but not limited to, at least one of, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica and/or combinations of two or more thereof.

The power rail PR may be between the first active pattern AP1 and the second active pattern AP2. The power rail PR may be in the lower insulating film 102. The lower insulating film 102 may surround the power rail PR. The power rail PR may extend in length in the second direction D2, but the present disclosure is not limited thereto.

The power rail PR is on the second side 100b of the first substrate 100. The power rail PR is in the lower insulating film 102. The power rail PR may be in contact with the lower side of the via pattern VP. The power rail PR may be in contact with the lower side of the second portion VP2 of the via pattern VP. The power rail PR may be electrically connected to the via pattern VP.

In some embodiments, the power rail PR may be connected to the first source/drain pattern 150. For example, the power rail PR may be connected to the first source/drain pattern 150 through the via pattern VP, a first via plug 195, and the first source/drain contact 170. A voltage may be applied to the first source/drain pattern 150 through the power rail PR. Although not shown, in some embodiments the power rail PR may also be connected to the second source/drain pattern 250 through another via pattern.

In some embodiments, the power rail PR may include a power rail barrier film PR_BL, and a power rail filling film PR_FL on the power rail barrier film PR_BL. The materials included in the power rail barrier film PR_BL and the power rail filling film PR_FL may be the same as the first source/drain barrier film 170BL and the first source/drain filling film 170FL, respectively, and description of the materials of the power rail barrier film PR_BL and the power rail filling film PR_FL is omitted here in favor of the previous description of the materials of the first source/drain barrier film 170BL and the first source/drain filling film 170FL. Although the power rail PR is shown as including a plurality of conductive films, the presently is not limited thereto. In some embodiments, the power rail PR may be a single film, in contrast to the shown example.

The via pattern VP may be on the power rail PR. The via pattern VP may penetrate or extend through the first interlayer insulating film 190, the etching stop film 160, the field insulating film 105, and the first substrate 100, and may be connected to the power rail PR. The lower side of the via pattern VP may be in contact with the upper side of the power rail PR.

The first interlayer insulating film 190 may not cover the upper side of the via pattern VP, and the upper side or upper surface of the via pattern VP may be free from contact with the first interlayer insulating film 190. For example, the upper side of the via pattern VP may be coplanar with the upper side of the first interlayer insulating film 190 for example in the third direction D3. In some embodiments, the upper side of the via pattern VP may be coplanar with the upper side of the first source/drain contact 170 and the upper side of the second source/drain contact 270. The upper side of the via pattern VP may be coplanar with the upper side of the gate contact 180 and the upper side of the gate capping film 145.

In some embodiments, the via pattern VP may include a first portion VP1 and a second portion VP2. The first portion VP1 of the via pattern VP may be on the first side 100a of the first substrate 100. The second portion VP2 of the via pattern VP may be in the first substrate 100. The first portion VP1 of the via pattern VP may be on the second portion VP2 of the via pattern VP.

The first portion VP1 of the via pattern VP may penetrate or extend through the first interlayer insulating film 190, the etching stop film 160, and the field insulating film 105. The upper side of the first portion VP1 of the via pattern VP may be the upper side of the via pattern VP.

The second portion VP2 of the via pattern VP may penetrate or extend through the first substrate 100. The upper side of the second portion VP2 of the via pattern VP may be coplanar with the first side 100a of the first substrate 100 for example in the third direction D3. The lower side of the second portion VP2 of the via pattern VP may be the lower side of the via pattern VP. In some embodiments, the lower side of the first portion VP1 of the via pattern VP may be coplanar with the second side 100b of the first substrate 100.

In some embodiments, one side of the via pattern VP may be connected to the power rail PR, and the other side thereof may be connected to the first source/drain pattern 150. One side of the via pattern VP may be in direct contact with the power rail PR. The other side of the via pattern VP may not be in direct contact (e.g., may be in indirect contact) with the first source/drain pattern 150. The other side of the via pattern VP may be connected to the first source/drain pattern 150 through the first source/drain contact 170 and the first via plug 195.

In some embodiments, the width of the first portion VP1 of the via pattern VP may gradually increase as a distance increases from the first side 100a of the first substrate 100 for example in the first direction D1. That is, the first portion VP1 of the via pattern VP may have a maximum width on the upper side of the via pattern VP. The width of the second portion VP2 of the via pattern VP may gradually increase a distance increases from the first side 100a of the first substrate 100. That is, the second portion VP2 of the via pattern VP may have a maximum width on the lower side of the via pattern VP.

In other words, the via pattern VP may have a minimum width at the boundary between the first portion VP1 and the second portion VP2 of the via pattern VP. Further, the width of the via pattern VP may gradually decrease and then increase a distance increases from the second side 100b of the first substrate 100. However, the inventive concepts of the present disclosure are not limited thereto.

The via pattern VP may include a conductive material. For example, the via pattern VP may include at least one of aluminum (Al), tungsten (W), cobalt (Co), ruthenium (Ru), silver (Ag), gold (Au), manganese (Mn), copper (Cu), and molybdenum (Mo).

An upper stop film 191 may be on the first interlayer insulating film 190, the gate capping film 145, the first source/drain contact 170, the second source/drain contact 270, the via pattern VP, and the gate contact 180. A second interlayer insulating film 192 may be on the upper stop film 191.

The upper stop film 191 may include a material having an etching selectivity with respect to the second interlayer insulating film 192. The upper stop film 191 may include, for example, at least one of silicon nitride (SiN), silicon oxynitride (SiON), silicon oxycarbonitride (SiOCN), silicon boronitride (SiBN), silicon oxyboronitride (SiOBN), silicon oxycarbide (SiOC), aluminum oxide (AlO), aluminum nitride (AlN), aluminum oxycarbide (AlOC), and/or combinations of two or more thereof. Although the upper stop film 191 is shown as being a single film, the present disclosure is not limited thereto. In some embodiments, in contrast to the shown example, the upper stop film 191 may not be formed. The second interlayer insulating film 192 may include, for example, at least one of silicon oxide, silicon nitride, silicon carbonitride, silicon oxynitride, and/or a low dielectric constant material.

The first via plug 195 may be in the second interlayer insulating film 192. The first via plug 195 may penetrate or extend through the upper stop film 191, and may be directly connected to the first source/drain contact 170 and the via pattern VP.

A portion of the first via plug 195 may cover (e.g., completely cover) the upper side of the first source/drain contact 170 and the upper side of the via pattern VP. Stated differently, the first source/drain contact 170 and the via pattern VP may each be connected to the single first via plug 195.

The first via plug 195 may include a first via barrier film 195BL and a first via filling film 195FL. The first via barrier film 195BL may extend along the side wall and bottom side of the first via filling film 195FL. The first via barrier film 195BL may include, for example, at least one of tantalum (Ta), tantalum nitride (TaN), titanium (Ti), titanium nitride (TiN), titanium silicon nitride (TiSiN), nickel (Ni), nickel boron (NiB), tungsten nitride (WN), tungsten carbonitride (WCN), zirconium (Zr), zirconium nitride (ZrN), vanadium (V), vanadium nitride (VN), niobium (Nb), niobium nitride (NbN), platinum (Pt), iridium (Ir), rhodium (Rh), and/or a two-dimensional (2D) material. The first via filling film 195FL may include, for example, at least one of aluminum (Al), tungsten (W), cobalt (Co), ruthenium (Ru), copper (Cu), silver (Ag), gold (Au), manganese (Mn), and/or molybdenum (Mo).

A second via plug 295 may be in the second interlayer insulating film 192. The second via plug 295 may penetrate or extend through the upper stop film 191 and may be connected to the second source/drain contact 270. A part of the second via plug 295 may cover (e.g., completely cover) the upper side of the second source/drain contact 270.

The second via plug 295 may include a second via barrier film 295BL and a second via filling film 295FL. The second via barrier film 295BL may extend along the side wall and bottom side of the second via filling film 295FL. The material included in the second via barrier film 295BL may be the same as the material included in the first via barrier film 195BL. The material included in the second via filling film 295FL may be the same as the material included in the first via filling film 195FL.

The first dummy pattern 320 may be on the first side 100a of the first substrate 100 for example in the first direction D1. The first dummy pattern 320 may be on the second interlayer insulating film 192. The first dummy pattern 320 may be in a first insulating film 310. The first dummy pattern 320 may penetrate or extend through the first insulating film 310 in the first direction D1.

For example, a height 310H of the first insulating film 310 in the first direction D1 may be equal to a depth 320D of the first dummy pattern 320 in the first direction D1. The upper side of the first insulating film 310 may be coplanar with the upper side of the first dummy pattern 320 for example in the second direction D2 and/or third direction D3. The lower side of the first insulating film 310 may be coplanar with the lower side of the first dummy pattern 320. The upper side of the first insulating film 310 may be in contact with a first adhesive film 330. A lower side of the first insulating film 310 may face the first side 100a of the first substrate 100.

The first insulating film 310 and the first dummy pattern 320 may each be formed of an insulating material. Each of the first insulating film 310 and the first dummy pattern 320 may be formed of different materials. For example, the first insulating film 310 may be formed of a silicon oxide film. The first dummy pattern 320 may be formed of a silicon nitride film. However, the inventive concepts of the present disclosure are not limited thereto.

The first adhesive film 330 may be provided on the first insulating film 310 and the first dummy pattern 320. Although the first adhesive film 330 may be formed of silicon carbonitride film (SiCN), the technical idea of the present disclosure is not limited thereto.

A semiconductor device according to some embodiments may further include a second substrate 400. The second substrate 400 may be on the first substrate 100. The second substrate 400 may include a third side 400a and a fourth side 400b that are opposite to each other in the first direction D1. The third side 400a may face the first side 100a.

The second substrate 400 may be bulk silicon or silicon-on-insulator (SOI). In contrast, the second substrate 400 may be a silicon substrate, or may include other materials, for example, but not limited to, silicon germanium, silicon germanium on insulator (SGOI), indium antimonide, lead tellurium, indium arsenide, indium phosphide, gallium arsenide or gallium antimonide. The second substrate 400 may be a glass substrate.

A second insulating film 410 may be on the third side 400a of the second substrate 400. The second insulating film 410 may be provided between the first side 100a of the first substrate 100 and the third side 400a of the second substrate 400. The second dummy pattern 420 may be in the second insulating film 410. The second dummy pattern 420 may penetrate or extend through the second insulating film 410 in the first direction D1.

For example, a height 410H of the second insulating film 410 in the first direction D1 may be equal to a depth 420D of the second dummy pattern 420 in the first direction D1. The upper side of the second insulating film 410 may be coplanar with the upper side of the second dummy pattern 420 for example in the second direction D2 and/or third direction D3. The lower side of the second insulating film 410 may be coplanar with the lower side of the second dummy pattern 420. The upper side of the second insulating film 410 may be coplanar with the third side 400a of the second substrate 400. The lower side of the second insulating film 410 may be in contact with a second adhesive film 430.

The second insulating film 410 and the second dummy pattern 420 may each be formed of an insulating material. Each of the second insulating film 410 and the second dummy pattern 420 may be formed of different materials. For example, the second insulating film 410 may be formed of a silicon oxide film. The second dummy pattern 420 may be formed of a silicon nitride film. However, the inventive concepts of the present disclosure are not limited thereto.

A second adhesive film 430 may be provided on the second insulating film 410 and the second dummy pattern 420. Although the second adhesive film 430 may be formed of silicon carbonitride film (SiCN), the inventive concepts of the present disclosure are not limited thereto. In some embodiments, the first adhesive film 330 and the second adhesive film 430 may be bonded to each other.

In some embodiments, the first dummy pattern 320 and the second dummy pattern 420 may overlap in the first direction D1. In other words, the second dummy pattern 420 may overlay all of a portion of the first dummy pattern 320 in the first direction D1. The first dummy pattern 320 may not overlap the second insulating film 410 in the first direction D1. Similarly, the second dummy pattern 420 may not overlap the first insulating film 310 in the first direction D1.

In some embodiments, the first dummy pattern 320 and the second dummy pattern 420 may be formed of the same material as each other. As an example, both the first dummy pattern 320 and the second dummy pattern 420 may be formed of a silicon nitride film. The first insulating film 310 and the second insulating film 410 may be formed of the same material as each other. As an example, both the first insulating film 310 and the second insulating film 410 may be formed of a silicon oxide film. The first dummy pattern 320 may be formed of a material different from that of the second insulating film 410. The second dummy pattern 420 may be formed of a different material from the first insulating film 310. However, the inventive concepts of the present disclosure are not limited thereto.

The semiconductor device according to some embodiments may include the first dummy pattern 320 and the second dummy pattern 420 between the first substrate 100 and the second substrate 400. Therefore, when forming the power rail PR on the second side 100b of the first substrate 100, damage or stress applied to the semiconductor device may be reduced, and a warpage phenomenon of the first substrate 100 may be prevented. Therefore, a semiconductor device with improved reliability may be fabricated.

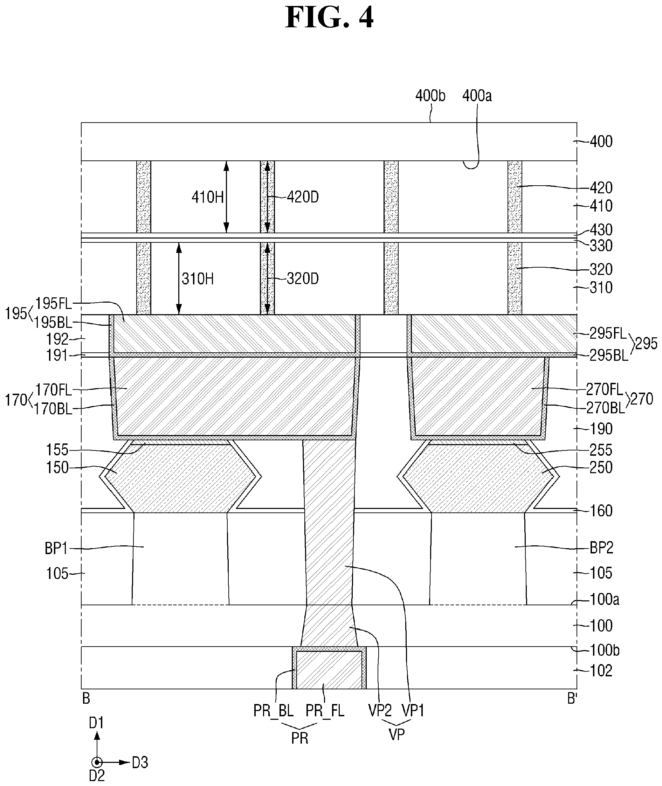

Hereinafter, semiconductor devices according to some embodiments of the present disclosure will be described with reference to FIGS. 4 to 23.

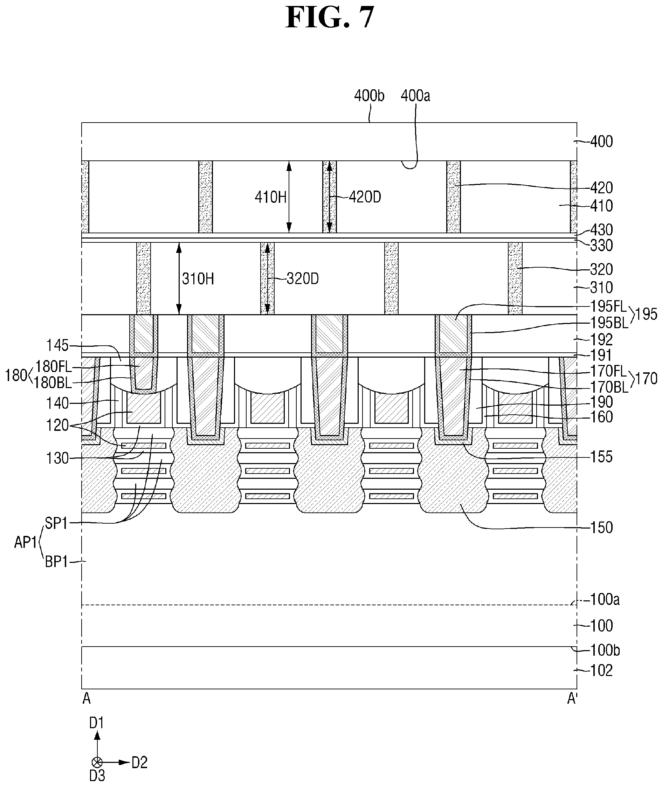

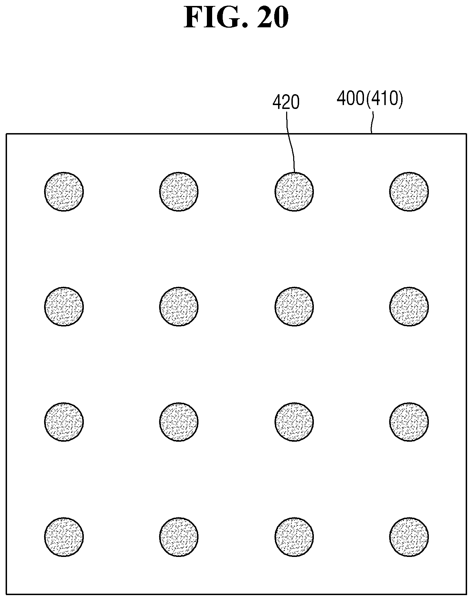

FIGS. 4 to 23 are diagrams for explaining semiconductor devices according to some embodiments. For reference, FIGS. 4 to 6 may be cross-sectional views taken along line B-B' of FIG. 1. FIGS. 7 to 19 may be cross-sectional views taken along line A-A' of FIG. 1. FIGS. 20 to 23 may be plan views for explaining the second dummy pattern according to some embodiments.

First, referring to FIG. 4, in some embodiments, the upper side of the via pattern VP may not be coplanar with the upper side of the first source/drain contact 170 for example in the third direction D3. The upper side of the via pattern VP may be in contact with a bottom side of the first source/drain contact 170. The via pattern VP may not extend to the upper side of the first interlayer insulating film 190. The upper side of the via pattern VP may be at a lower level than the upper side of the first interlayer insulating film 190.

The via pattern VP may not overlap the first source/drain contact 170 and the second source/drain contact 270 in the third direction D3. The first portion VP1 of the via pattern VP may not overlap the first source/drain contact 170 and the second source/drain contact 270 in the third direction D3.

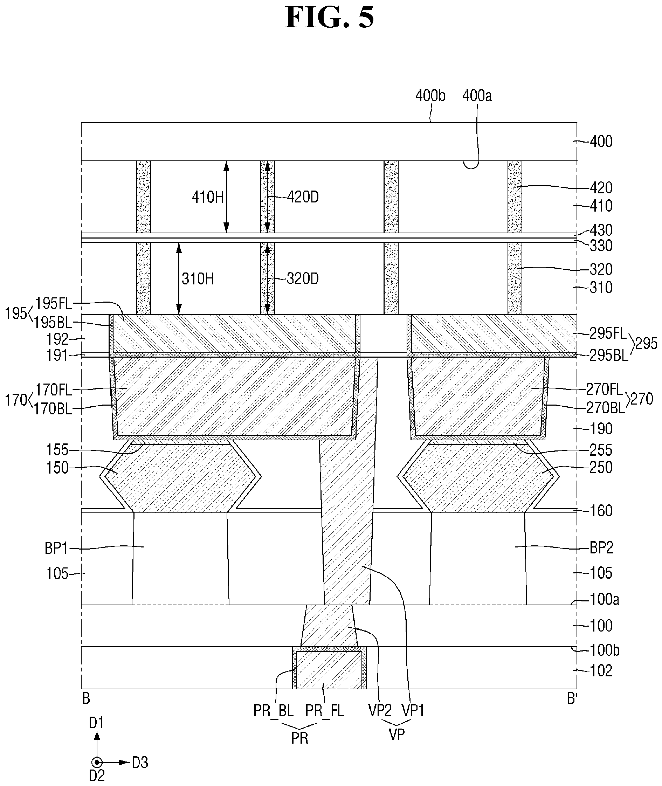

Referring to FIG. 5, in some embodiments, the first portion VP1 and the second portion VP2 of the via pattern VP may be offset from each other. The first portion VP1 and the second portion VP2 of the via pattern VP may not be aligned in the first direction D1. At least a part of the first source/drain contact 170 may overlap the via pattern VP in the first direction D1 and the third direction D3. In other words, at least a portion and potentially only a portion of the fist via portion VP1 may overlay the second via portion VP2 in the first direction. At least a part of the first source/drain contact 170 may be in the via pattern VP.

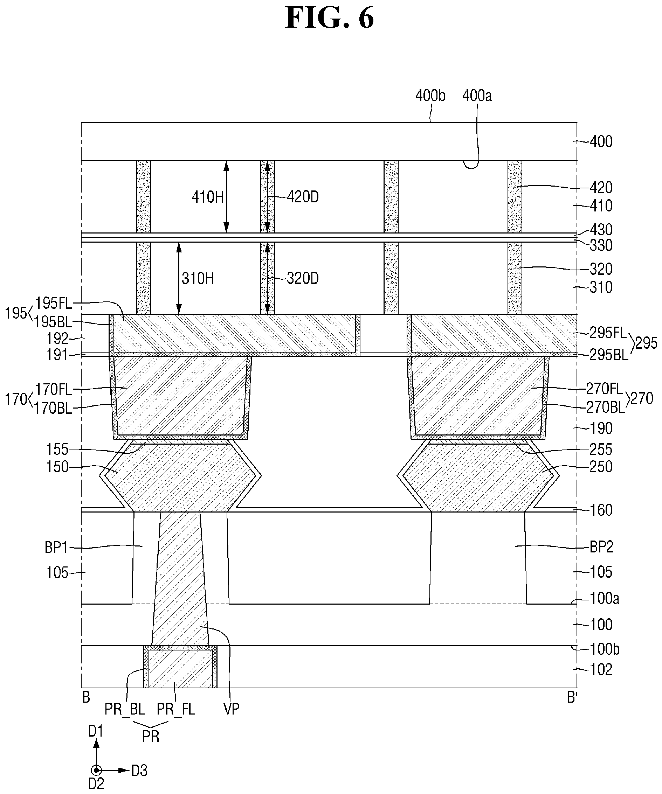

Referring to FIG. 6, in some embodiments, the via pattern VP may be directly connected to the first source/drain pattern 150. The via pattern VP may penetrate or extend through the first substrate 100 and the first lower pattern BP1 in the first direction D1. The via pattern VP may be in direct contact with the bottom side of the first source/drain pattern 150.

The via pattern VP may include only the second portion. That is, the via pattern VP may be etched from the second side 100b of the first substrate 100, but may not be etched from the upper side of the first interlayer insulating film 190. The width of the via pattern VP may gradually decrease a distance increases from the second side 100b of the first substrate 100 in the first direction D1. That is, the width of the via pattern VP may have a minimum value on the upper side of the via pattern VP, and a maximum value on the lower side of the via pattern VP. The lower side of the via pattern VP may be coplanar with the second side 100b of the first substrate 100, and the upper side of the via pattern VP may be coplanar with the upper side of the first lower pattern BP1.

Referring to FIG. 7, in some embodiments, the first dummy pattern 320 and the second dummy pattern 420 may be offset in the first direction D1. The first dummy pattern 320 and the second dummy pattern 420 may not overlap in the first direction D1. The first dummy pattern 320 may not overlay the second dummy pattern 420 in the first direction D1. The first dummy pattern 320 and the second dummy pattern 420 may not be aligned in the first direction D1.

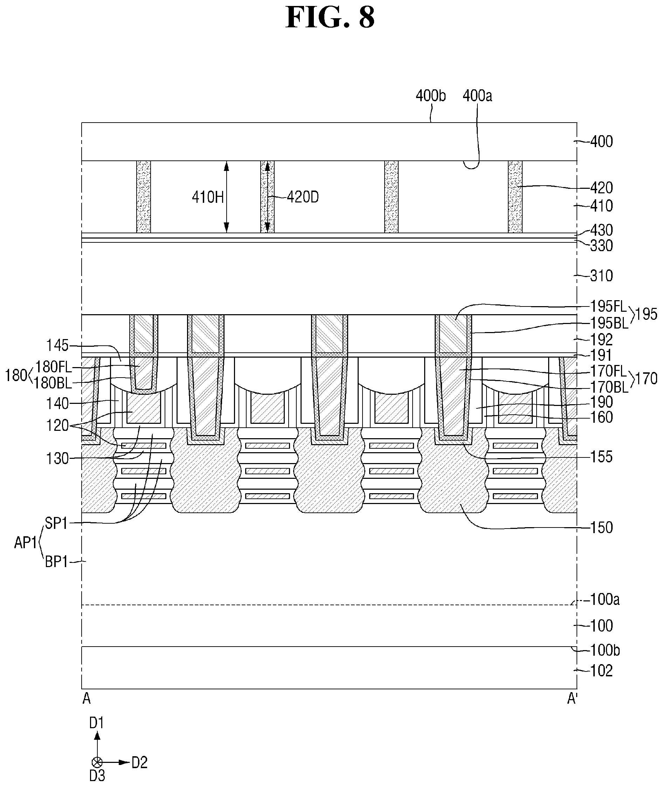

Referring to FIG. 8, the semiconductor device according to some embodiments may not include the first dummy pattern 320. The first dummy pattern 320 may not be in the first insulating film 310. The first adhesive film 330 may be on the first insulating film 310, and the first adhesive film 330 may be bonded to the second adhesive film 430. The second dummy pattern 420 may be on the second adhesive film 430.

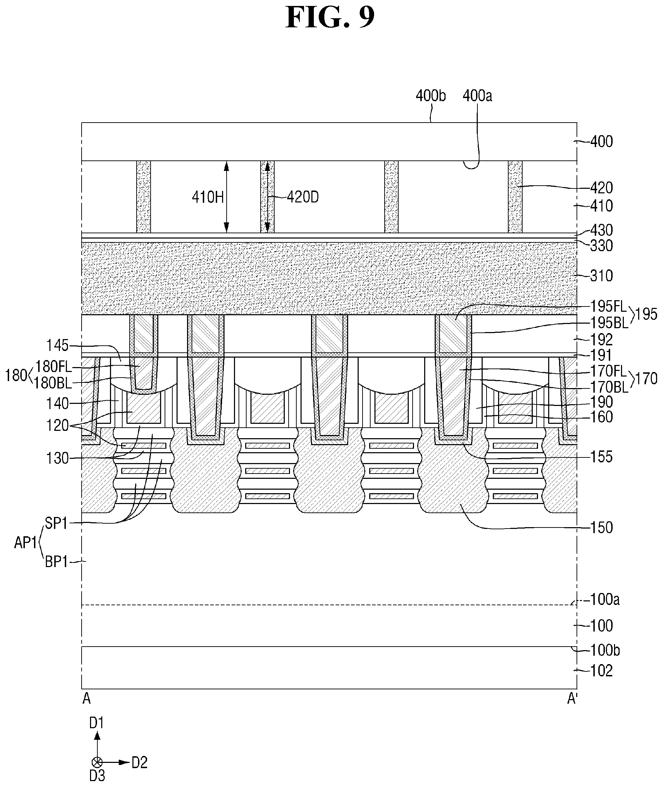

Referring to FIG. 9, the semiconductor device according to some embodiments may not include the first dummy pattern 320. The first insulating film 310 may be formed of a silicon nitride film. That is, the first insulating film 310 may be formed of the same material as the second dummy pattern 420. The first insulating film 310 may be formed of a different material from that of the second insulating film 410.

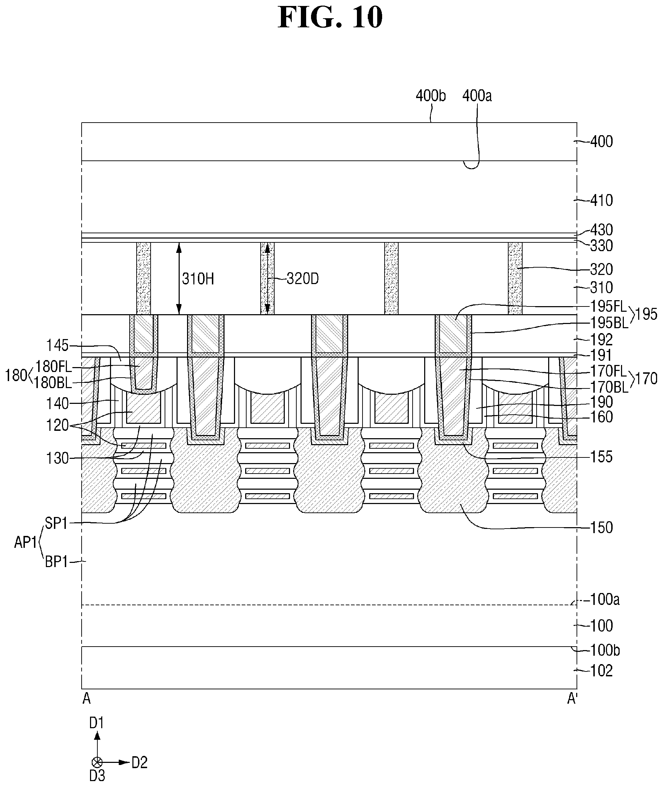

Referring to FIG. 10, the semiconductor device according to some embodiments may not include the second dummy pattern 420. The first adhesive film 330 is on the first insulating film 310 and the first dummy pattern 320, and the first adhesive film 330 may be bonded to the second adhesive film 430. The second insulating film 410 may be on the second adhesive film 430. The second dummy pattern 420 may not be in the second insulating film 410.

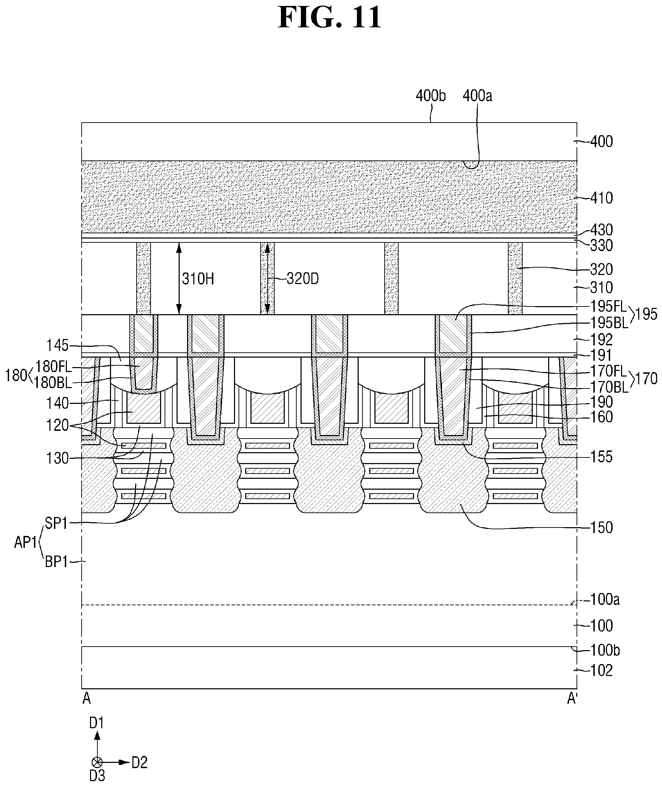

Referring to FIG. 11, the semiconductor device according to some embodiments may not include the second dummy pattern 420. The second insulating film 410 may be formed of a silicon nitride film. That is, the second insulating film 410 may be formed of the same material as the first dummy pattern 320. The second insulating film 410 may be formed of a different material from that of the first insulating film 310.

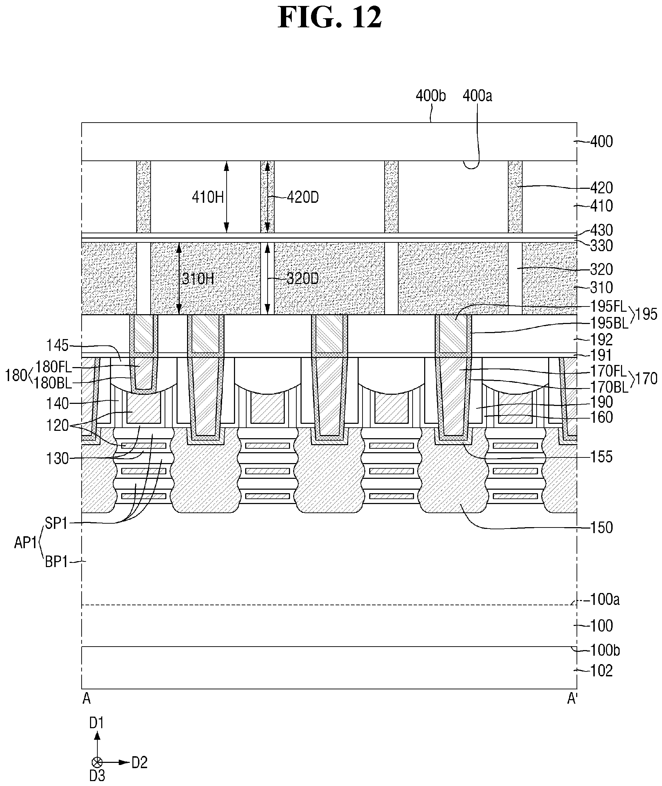

Referring to FIG. 12, the first insulating film 310 and the second insulating film 410 may be formed of different materials from each other. As an example, the first insulating film 310 may be formed of a silicon nitride film, and the second insulating film 410 may be formed of a silicon oxide film. However, the inventive concepts of the present disclosure are not limited thereto. In some embodiments, the first insulating film 310 may be formed of a silicon oxide film, and the second insulating film 410 may be formed of a silicon nitride film.

The first dummy pattern 320 and the second dummy pattern 420 may be formed of different materials from each other. As an example, the first dummy pattern 320 may be formed of a silicon oxide film, and the second dummy pattern 420 may be formed of a silicon nitride film. However, the inventive concepts of the present disclosure are not limited thereto. In some embodiments, the first dummy pattern 320 may be formed of a silicon nitride film, and the second dummy pattern 420 may be formed of a silicon oxide film.

In some embodiments, the first insulating film 310 may be formed of the same material as that of the second dummy pattern 420. The second insulating film 410 may be formed of the same material as the first dummy pattern 320.

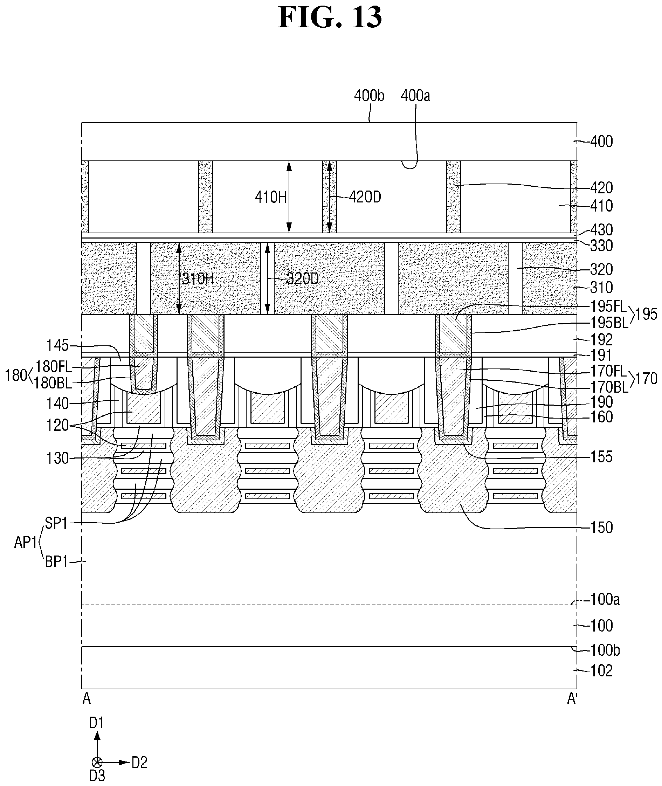

Referring to FIG. 13, the first insulating film 310 and the second insulating film 410 may be formed of different materials from each other, and the first dummy pattern 320 and the second dummy pattern 420 may be formed of different materials from each other. The first insulating film 310 may be formed of the same material as the second dummy pattern 420, and the second insulating film 410 may be formed of the same material as the first dummy pattern 320. In some embodiments, the first dummy pattern 320 may not overlap the second dummy pattern 420 in the first direction D1. The first dummy pattern 320 may be offset from the second dummy pattern 420 in the first direction D1.

For example, the first insulating film 310 and the second dummy pattern 420 may be formed of a silicon nitride film. The second insulating film 410 and the first dummy pattern 320 may be formed of a silicon oxide film. However, the inventive concepts of the present disclosure are not limited thereto. In some embodiments, the first insulating film 310 and the second dummy pattern 420 may be formed of a silicon oxide film, and the second insulating film 410 and the first dummy pattern 320 may be formed of a silicon nitride film.

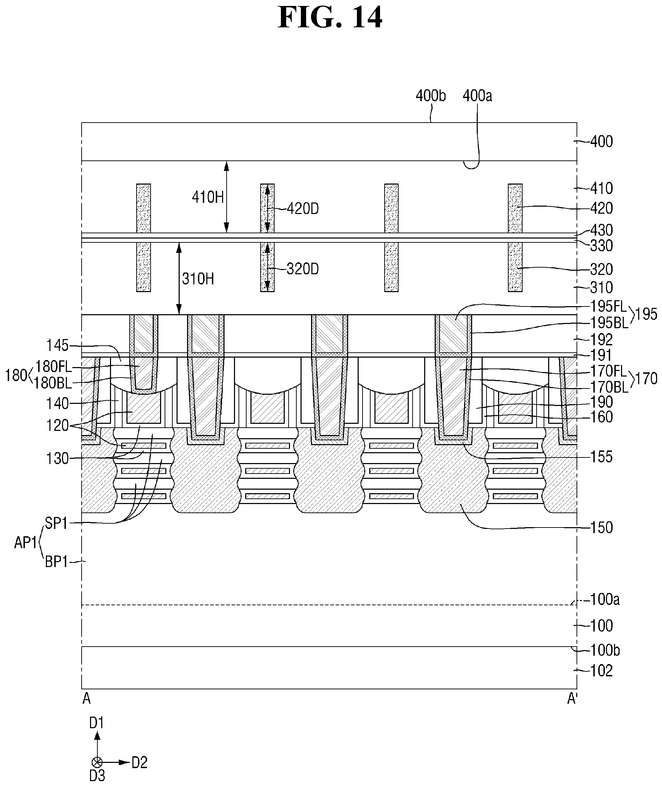

Referring to FIG. 14, the first dummy pattern 320 may not penetrate or extend through the first insulating film 310 in the first direction D1. The first dummy pattern 320 may not penetrate or extend through all of the first insulating film 310 in the first direction D1. The first dummy pattern 320 may penetrate or extend through only a portion of the first insulating film 310 in the first direction D1.

The upper side of the first dummy pattern 320 may be coplanar with the upper side of the first insulating film 310. However, the lower side of the first dummy pattern 320 may be at a different level from the lower side of the first insulating film 310, and may not be coplanar from the lower side of the first insulating film 310. With the first side 100a of the first substrate 100 as a reference, the lower side of the first dummy pattern 320 may be higher than the lower side of the first insulating film 310. A height 310H of the first insulating film 310 in the first direction D1 may be greater than a depth 320D of the first dummy pattern 320 in the first direction D1.

The second dummy pattern 420 may not penetrate or extend through the second insulating film 410 in the first direction D1. The second dummy pattern 420 may not penetrate or extend through all of the second insulating film 410 in the first direction D1. The second dummy pattern 420 may penetrate or extend through only a portion of the second insulating film 410 in the first direction D1.

The lower side of the second dummy pattern 420 may be coplanar with the lower side of the second insulating film 410. However, the upper side of the second dummy pattern 420 may be at a different level than an upper side of the second insulating film 410, and may not be coplanar with the upper side of the second insulating film 410. The upper side of the second dummy pattern 420 may be lower than the upper side of the second insulating film 410, with the first side 100a of the first substrate 100 as a reference. A height 410H of the second insulating film 410 in the first direction D1 may be greater than a depth 420D of the second dummy pattern 420 in the first direction D1.

At this time, the first dummy pattern 320 and the second dummy pattern 420 may overlap in the first direction D1. However, the inventive concepts of the present disclosure are not limited thereto.

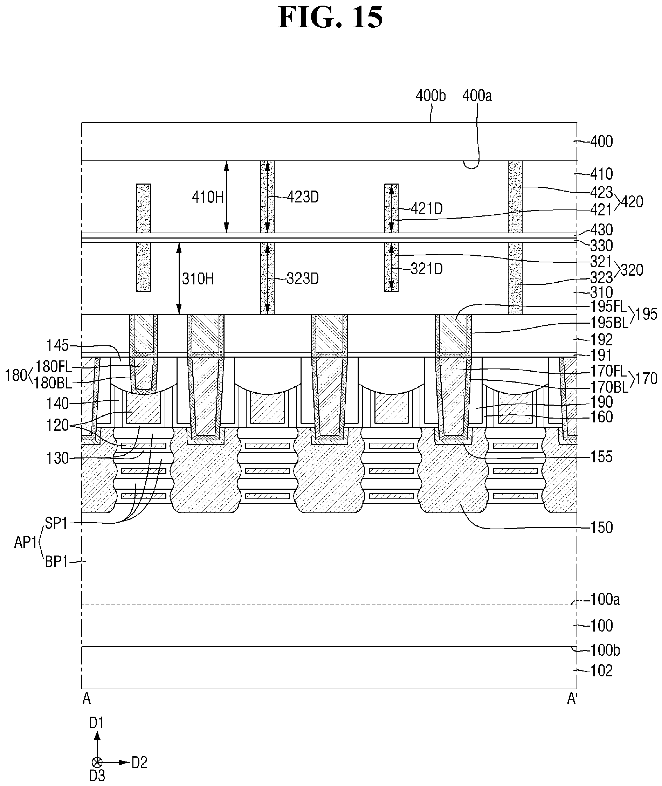

Referring to FIG. 15, the first dummy pattern 320 may include a first sub-pattern 321 and a second sub-pattern 323. The second dummy pattern 420 may include a third sub-pattern 421 and a fourth sub-pattern 423.

The first sub-pattern 321 may not penetrate or extend through (e.g., may not completely extend through) the first insulating film 310 in the first direction D1. The second sub-pattern 323 may penetrate or extend through (e.g., may extend completely through) the first insulating film 310 in the first direction D1. The upper side of the first sub-pattern 321, the upper side of the second sub-pattern 323, and the upper side of the first insulating film 310 may be coplanar with each other. Meanwhile, the lower side of the first sub-pattern 321 may not be coplanar with the lower side of the second sub-pattern 323 and the lower side of the first insulating film 310. The lower side of the first sub-pattern 321 may be higher than the lower side of the second sub-pattern 323 and the lower side of the first insulating film 310 with the first side 100a of the first substrate 100 as a reference.

In some embodiments, a depth 321D or thickness of the first sub-pattern 321 in the first direction D1 may be smaller than a depth 323D or thickness of the second sub-pattern 323 in the first direction D1. Similarly, the depth 321D of the first sub-pattern 321 in the first direction D1 may be smaller than the height 310H of the first insulating film 310 in the first direction D1. The depth 323D of the second sub-pattern 323 in the first direction D1 may be equal to the height 310H of the first insulating film 310 in the first direction D1.

The third sub-pattern 421 may not penetrate or extend through (e.g., may not completely extend through) the second insulating film 410 in the first direction D1. The fourth sub-pattern 423 may penetrate or extend through (e.g., may extend completely through) the second insulating film 410 in the first direction D1. The lower side of the third sub-pattern 421, the lower side of the fourth sub-pattern 423, and the lower side of the second insulating film 410 may be coplanar with each other. On the other hand, the upper side of the third sub-pattern 421 may not be coplanar with the upper side of the fourth sub-pattern 423 and the upper side of the second insulating film 410. The upper side of the third sub-pattern 421 may be lower than the upper side of the fourth sub-pattern 423 and the lower side of the second insulating film 410 with the first side 100a of the first substrate 100 as a reference.

In some embodiments, the depth 421D or thickness of the third sub-pattern 421 in the first direction D1 may be smaller than the depth 423D of the fourth sub-pattern 423 in the first direction D1. Similarly, the depth 421D or thickness of the third sub-pattern 421 in the first direction D1 may be smaller than the height 410H of the second insulating film 410 in the first direction D1. The depth 423D of the fourth sub-pattern 423 in the first direction D1 may be equal to the height 410H of the second insulating film 410 in the first direction D1.

In some embodiments, the first sub-pattern 321 may overlap the third sub-pattern 421 in the first direction D1. The second sub-pattern 323 may overlap the fourth sub-pattern 423 in the first direction D1. In other words, the first sub-pattern 321 may overlay the third sub-pattern 421 in the first direction D1, and/or the second sub-pattern 323 may overlay the fourth sub-pattern 423 in the first direction D1. However, the inventive concepts of the present disclosure are not limited thereto.

Further, in FIG. 15, the first sub-pattern 321 is shown as being between the adjacent second sub-patterns 323, but the inventive concepts of the present disclosure are not limited thereto. In some embodiments, two or more first sub-patterns 321 may be placed between adjacent second sub-patterns 323. In some embodiments, two or more third sub-patterns 421 may be placed between adjacent fourth sub-patterns 423.

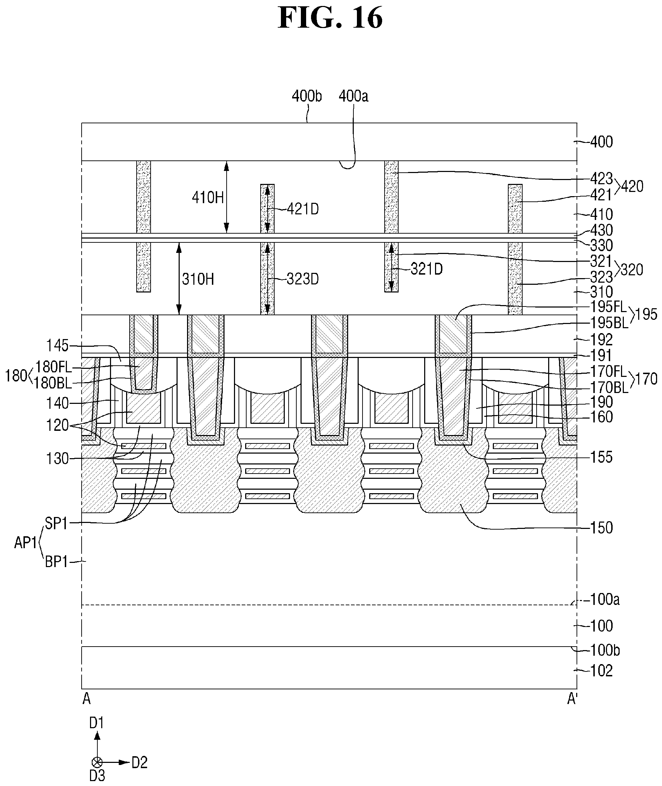

Referring to FIG. 16, the first sub-pattern 321 may overlap the fourth sub-pattern 423 in the first direction D1, and the second sub-pattern 323 may overlap the third sub-pattern 421 in the first direction D1. That is, a shorter dummy pattern among the first dummy patterns 320 may overlap a longer dummy pattern among the second dummy patterns 420. The longer dummy pattern among the first dummy patterns 320 may overlap the shorter dummy pattern among the second dummy patterns 420.

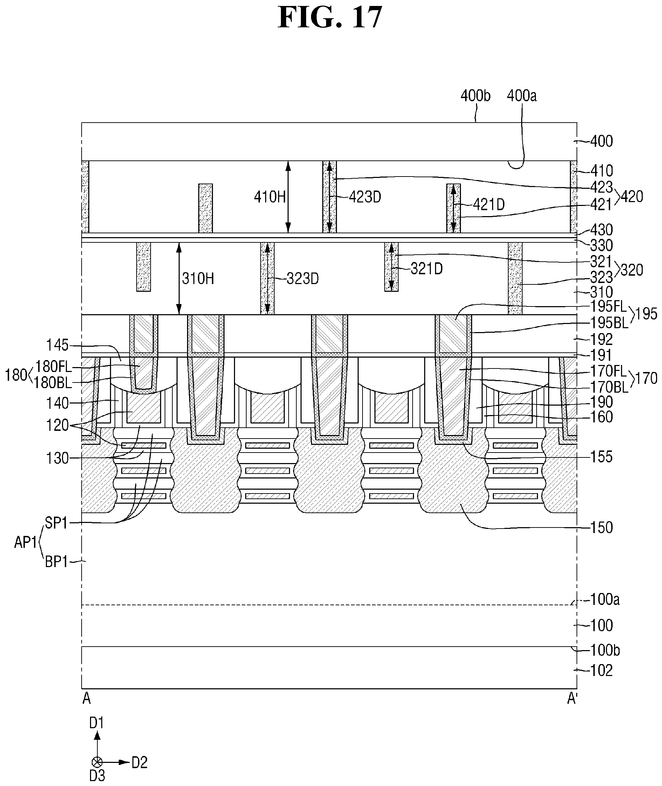

Referring to FIG. 17, the first sub-pattern 321, the second sub-pattern 323, the third sub-pattern 421, and the fourth sub-pattern 423 may not overlap in the first direction D1. The first sub-pattern 321, the second sub-pattern 323, the third sub-pattern 421, and the fourth sub-pattern 423 may be offset in the first direction D1.

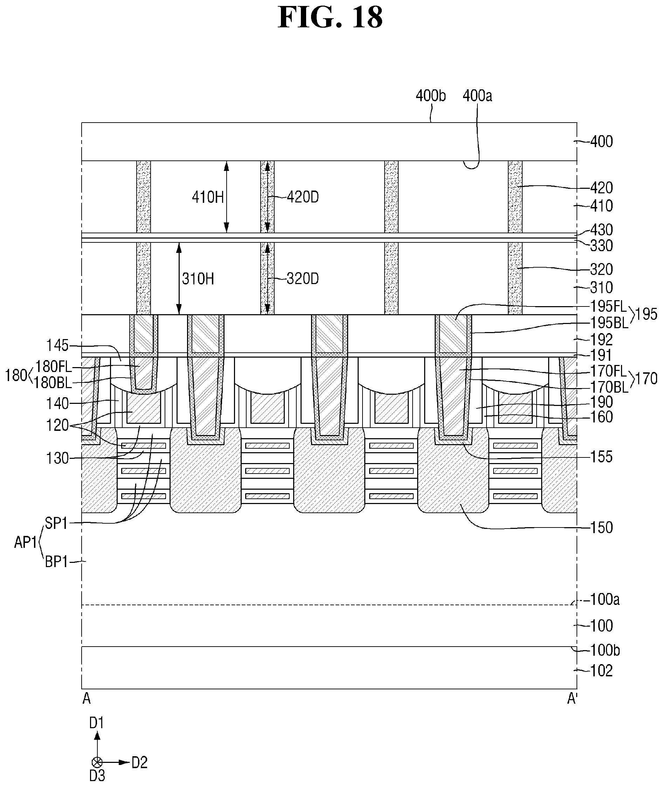

Referring to FIG. 18, the side walls of the first source/drain pattern 150 may not have a wavy shape. Although not shown, the side walls of the second source/drain pattern 250 may also not have a wavy shape.

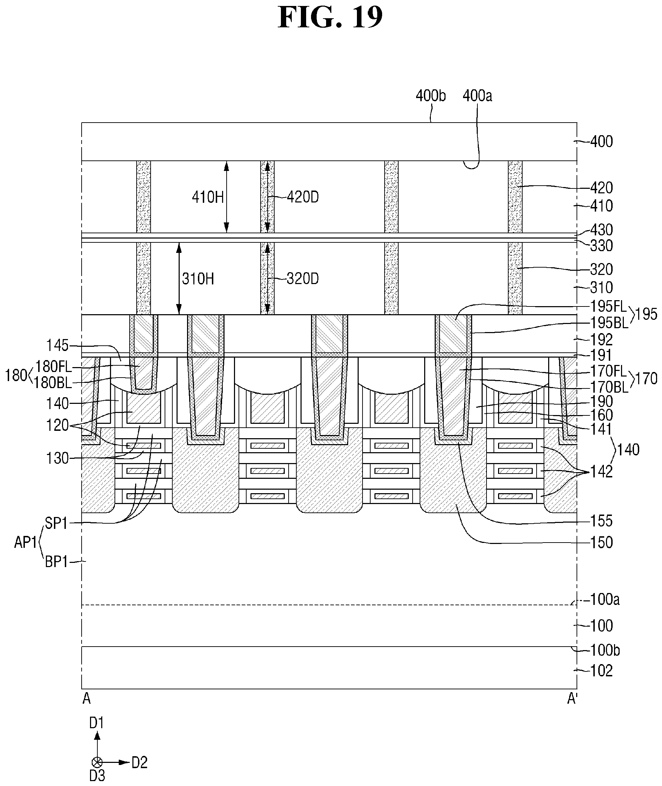

Referring to FIG. 19, the gate spacer 140 may include an outer spacer 141 and an inner spacer 142. The inner spacer 142 may be between the first lower pattern BP1 and the first sheet pattern SP1, and between the adjacent first sheet patterns SP1. Although not shown, the inner spacer 142 may be between the second lower pattern BP2 and the second sheet pattern, and between the adjacent second sheet patterns.

Referring to FIGS. 20 to 23, when viewed in a plan view, the second dummy pattern 420 may have at least one of a circular shape, a square shape, and a bar shape.

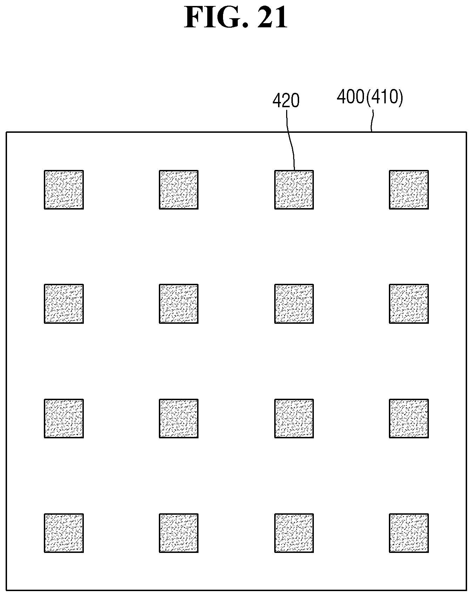

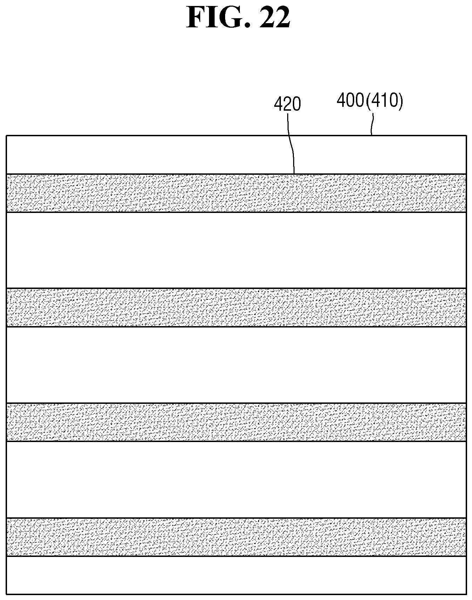

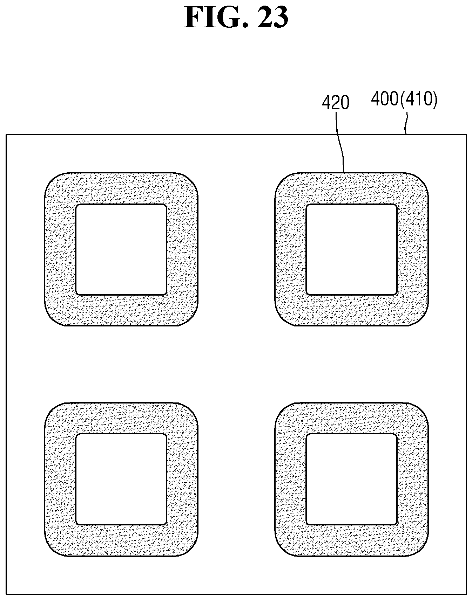

For example, in FIG. 20, the second dummy pattern 420 may have a circular shape when viewed in a plan view. In FIG. 21, the second dummy pattern 420 may have a square shape when viewed in a plan view. In FIG. 22, the second dummy pattern 420 may have a bar shape when viewed in a plan view. In FIG. 23, the second dummy pattern 420 may have a closed curve shape when viewed in a plan view. However, the inventive concepts of the present disclosure are not limited thereto. Although not shown, the shape of the first dummy pattern 320 may be the same as the shape of the second dummy pattern 420.

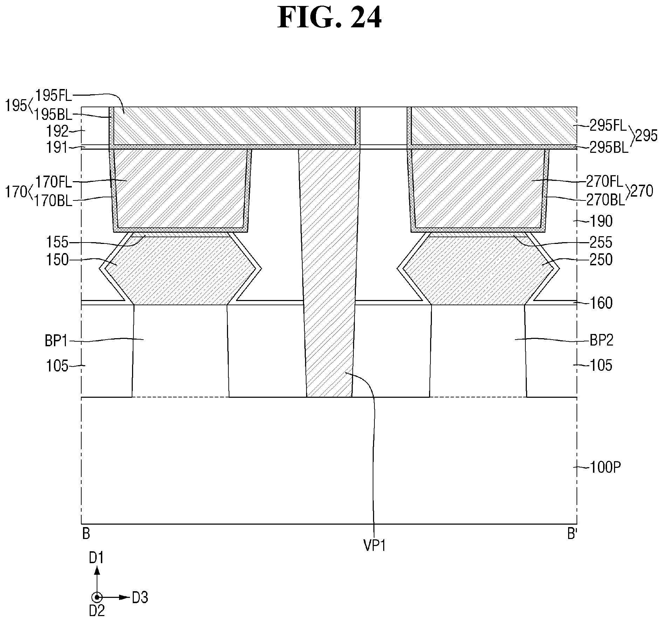

Hereinafter, a method for fabricating the semiconductor device according to some embodiments of the present disclosure will be described with reference to FIGS. 24 to 35. FIGS. 24 to 35 are intermediate diagrams for explaining a method for fabricating a semiconductor device according to some embodiments of the present disclosure. For reference, FIGS. 24 to 35 may be intermediate diagrams for explaining a method for fabricating a semiconductor device having the cross section of FIG. 3.

First, referring to FIG. 24, a pre-first substrate 100P may be provided. The first pre-substrate 100P may be bulk silicon or SOI (silicon-on-insulator). In contrast, the pre-first substrate 100P may be a silicon substrate, or may include other materials, for example, but not limited to, silicon germanium, SGOI (silicon germanium on insulator), indium antimonide, lead telluride, indium arsenide, indium phosphide, gallium arsenide, or gallium antimonide.

First and second lower patterns BP1 and BP2 may be formed on the pre-first substrate 100P. The field insulating film 105 that covers side walls of the first and second lower patterns BP1 and BP2 may be formed.

The first source/drain pattern 150 may be formed on the first lower pattern BP1. The second source/drain pattern 250 may be formed on the second lower pattern BP2. The etching stop film 160 may be formed along the profile of the first source/drain pattern 150, the upper side of the field insulating film 105, and the profile of the second source/drain pattern 250.

Subsequently, the first interlayer insulating film 190 may be formed on the pre-first substrate 100P. The first interlayer insulating film 190 may cover the etching stop film 160. Next, the first source/drain contact 170 may be formed on the first source/drain pattern 150, and the second source/drain contact 270 may be formed on the second source/drain pattern 250.

A first portion VP1 of the via pattern may be formed to penetrate or extend through the first interlayer insulating film 190, the etching stop film 160, and the field insulating film 105. The first portion VP1 of the via pattern may be formed on the pre-first substrate 100P.

Subsequently, the upper stop film 191 and the second interlayer insulating film 192 may be formed. First, the upper stop film 191 may be formed along the upper side of the first source/drain contact 170, the upper side of the first interlayer insulating film 190, the upper side of the second source/drain conta ct 270, and the upper side of the first portion VP1 of the via pattern. The second interlayer insulating film 192 may be formed on the upper stop film 191.

The first via plug 195 and the second via plug 295 may be formed in the second interlayer insulating film 192. The first via plug 195 may be connected to the first source/drain contact 170 and the first portion VP1 of the via pattern. The second via plug 295 may be connected to the second source/drain contact 270.

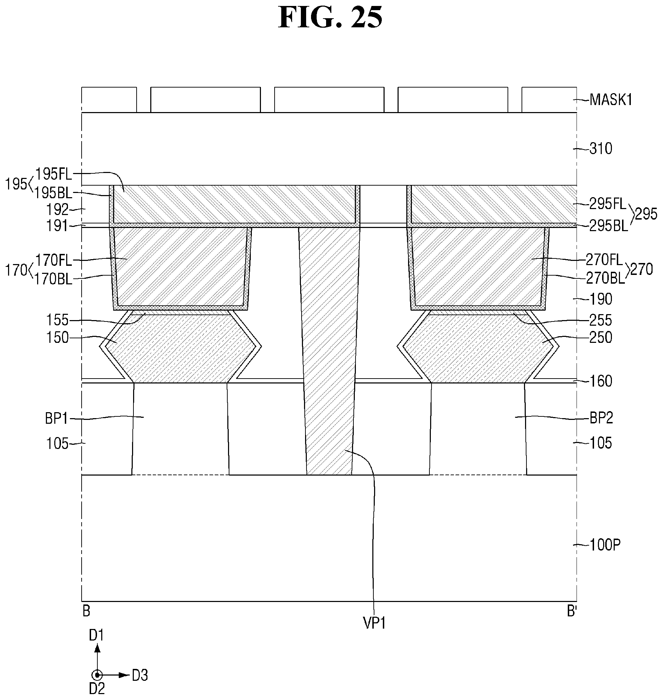

Referring to FIG. 25, the first insulating film 310 may be formed on the second interlayer insulating film 192. The first insulating film 310 may be formed of a silicon oxide film. A first mask film MASK1 may be formed on the first insulating film 310. The first mask film MASK1 may have an opening that roughly defines the position of the first dummy pattern 320. The first mask film MASK1 may be formed of at least one of a photoresist film, an ACL (Amorphous Carbon Layer), an SOH (Spin on Hardmask), an SOC (Spin on Carbon), and a silicon nitride film.

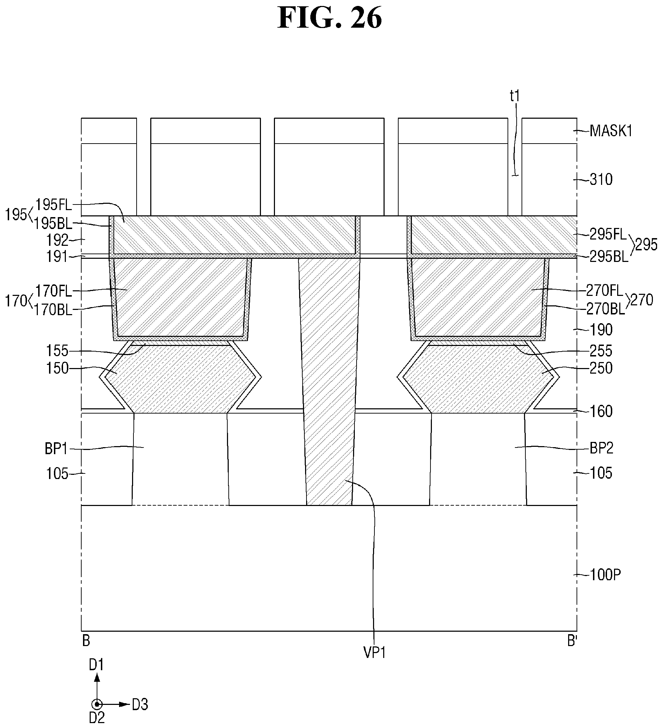

Referring to FIG. 26, the first insulating film 310 may be etched, using the first mask film MASK1 as an etching mask. A first trench t1 may be formed by etching the first insulating film 310. The first trench t1 may penetrate or extend through the first insulating film 310 in the first direction D 1.

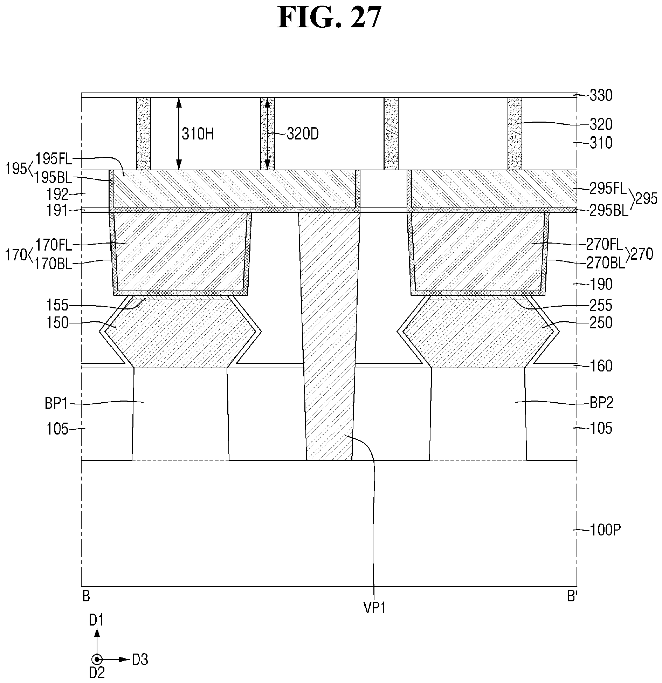

Referring to FIG. 27, the first dummy pattern 320 may be formed in the first trench 11. The first dummy pattern 320 may be formed of a different material from that of the first insulating film 310. As an example, the first dummy pattern 320 may be formed of silicon nitride film. Subsequently, the first adhesive film 330 may be formed on the first dummy pattern 320 and the first insulating film 310.

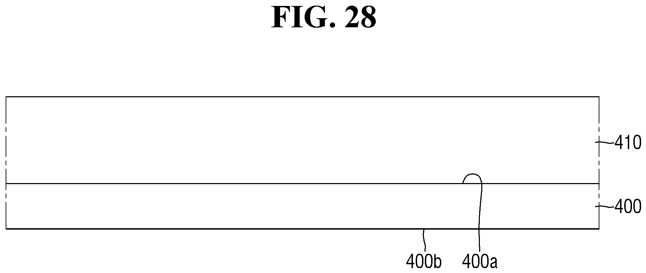

Referring to FIG. 28, the second substrate 400 may be provided. The second substrate 400 may be a carrier substrate. The second substrate 400 includes a third side 400a and a fourth side 400b that are opposite to each other. The second insulating film 410 may be formed on the third side 400a of the second substrate 400. The second insulating film 410 may be formed of, but is not limited to, a silicon oxide film.

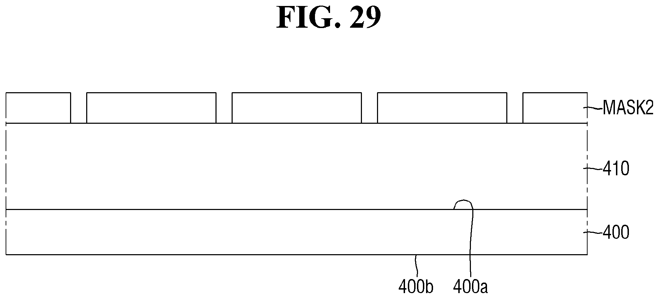

Referring to FIG. 29, a second mask film MASK2 may be formed on the second insulating film 410. The second mask film MASK2 may have an opening that roughly defines the position of the second dummy pattern 420. The second mask film MASK2 may be formed of at least one of a photoresist film, an ACL (Amorphous Carbon Layer), an SOH (Spin on Hardmask), an SOC (Spin on Carbon), and a silicon nitride film.

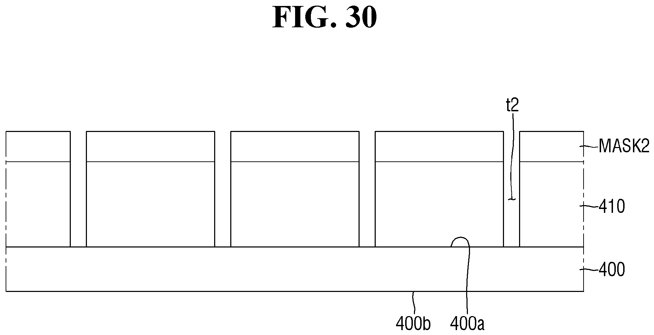

Referring to FIG. 30, the second insulating film 410 may be etched, using the second mask film MASK2 as an etching mask. A second trench t2 may be formed by etching the second insulating film 410. The second trench t2 may penetrate or extend through the second insulating film 410.

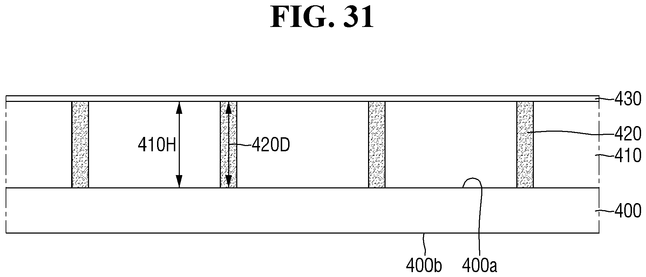

Referring to FIG. 31, the second dummy pattern 420 may be formed in the second trench t2. The second dummy pattern 420 may be formed of a material different from that of the second insulating film 410. As an example, the second dummy pattern 420 may be formed of a silicon nitride film. Subsequently, a second adhesive film 430 may be formed on the second dummy pattern 420 and the second insulating film 410.

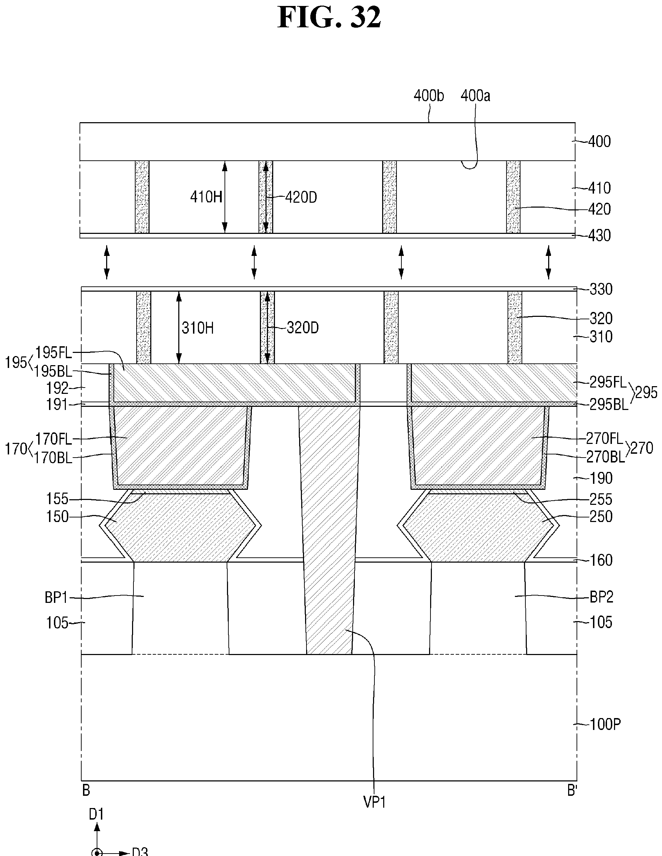

Referring to FIG. 32, the second adhesive film 430 may be bonded onto the first adhesive film 330. That is, the second adhesive film 430, the second insulating film 410, the second dummy pattern 420, and the second substrate 400 may be provided on the pre-first substrate 100P. At this time, the third side 400a of the second substrate 400 may face the pre-first substrate 100P.

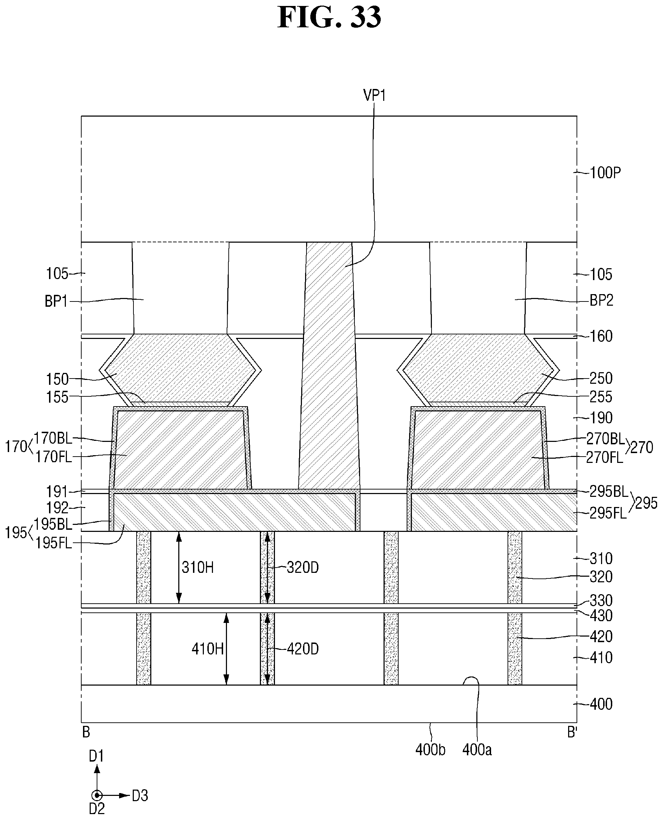

Referring to FIG. 33, the semiconductor device may be rotated by 180 degrees.

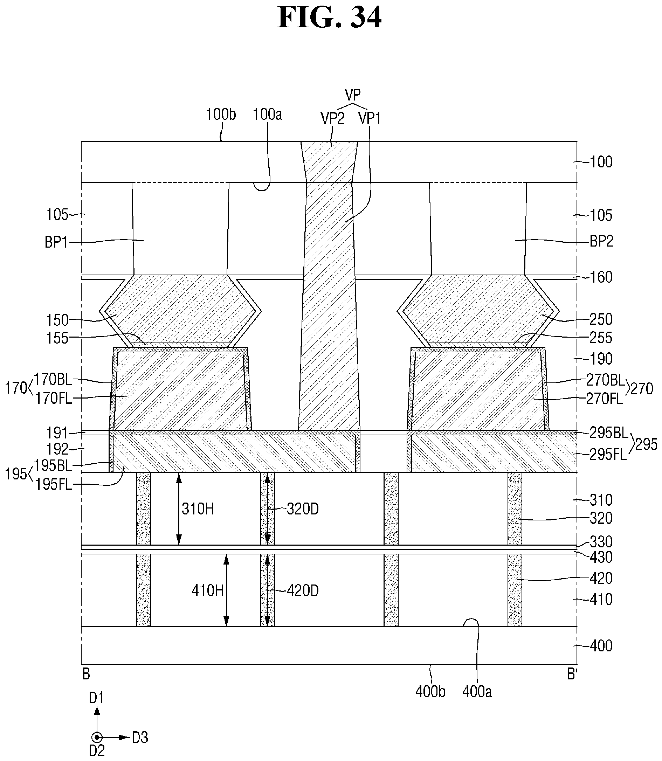

Referring to FIG. 34, the first substrate 100 may be formed by removing the pre-first substrate 100P.

The pre-first substrate 100P may be removed, using a planarization process. The first substrate 100 includes a first side 100a and a second side 100b that are opposite to each other. The first side 100a of the first substrate 100 faces the third side 400a of the second substrate 400. In the process of removing the pre-first substrate 100P, damage or stress may be applied to the semiconductor device. However, according to some embodiments of the present disclosure, it is possible to reduce damage or stress applied to the semiconductor device in the process of forming the first substrate 100, the via pattern VP, and the power rail PR, since the first dummy pattern 320 and the second dummy pattern 420 are provided. Therefore, a semiconductor device with improved reliability may be fabricated.

Subsequently, a second portion VP2 of the via pattern may be formed in the first substrate 100. The second portion VP2 of the via pattern may be connected to the first portion VP1 of the via pattern. The first portion VP1 of the via pattern and the second portion VP2 of the via pattern may constitute the via pattern VP.

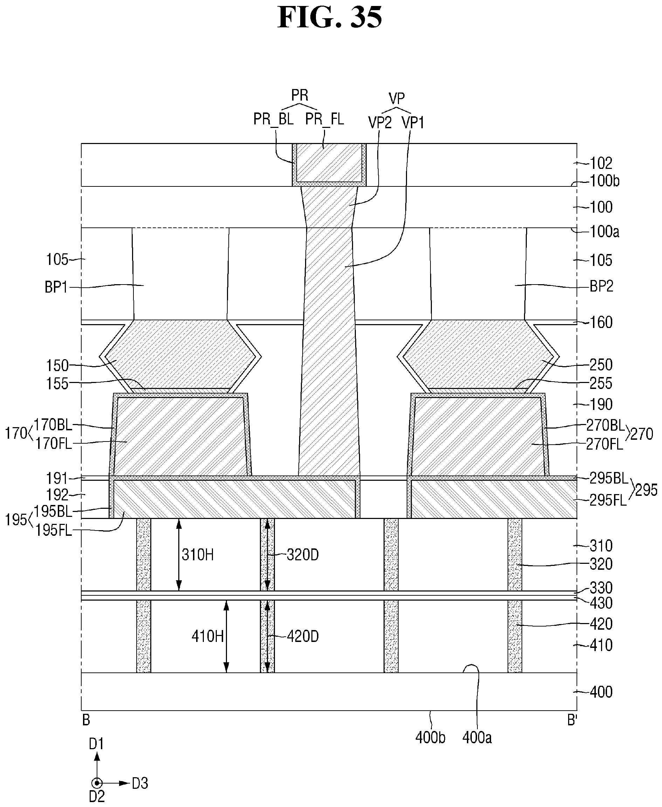

Referring to FIG. 35, the lower insulating film 102 may be formed on the second side 100b of the first substrate 100. The power rail PR may be formed in the lower insulating film 102.

In concluding the detailed description, those skilled in the art will appreciate that many variations and modifications may be made to the preferred embodiments without substantially departing from the inventive concepts of the present disclosure. Therefore, the disclosed embodiments of the disclosure are used in a generic and descriptive sense only and not for purposes of limitation.

Embodiments are set out in the following clauses:
Clause 1: A semiconductor device comprising:
   a first substrate which includes a first side and a second side that are opposite from each other in a first direction;
   a lower pattern on the first side of the first substrate, the lower pattern extending in a second direction that intersects the first direction;
   a plurality of sheet patterns which are spaced apart from each other in the first direction on the lower pattern;
   a gate electrode surrounding portions of the plurality of sheet patterns on the first side of the first substrate, the gate electrode extending in a third direction that intersects the first direction and the second direction;
   a source/drain pattern which is on a first side of the gate electrode and connected to the plurality of sheet patterns;
   a power rail which is on the second side of the first substrate and which extends in the second direction;
   a via pattern which extends through the first substrate in the first direction, the via pattern connected to the power rail and to the source/drain pattern;
   a first dummy pattern that includes an insulating material on the via pattern;
   a second substrate which includes, on the first dummy pattern, a third side that faces the first side, and a fourth side opposite from the third side in the first direction; and
   a second dummy pattern on the third side of the second substrate, the second dummy pattern including an insulating material,
   wherein the first dummy pattern and the second dummy pattern overlap each other in the first direction.
Clause 2: The semiconductor device of clause 1, wherein the first dummy pattern and the second dummy pattern include the same material.
Clause 3: The semiconductor device of clause 1, wherein the first dummy pattern and the second dummy pattern include different materials from each other.
Clause 4: The semiconductor device of any preceding clause, wherein the first dummy pattern includes a first sub-pattern and a second sub-pattern, and
   wherein a depth of the first sub-pattern in the first direction is different from a depth of the second sub-pattern in the first direction.
Clause 5: The semiconductor device of any preceding clause, wherein the second dummy pattern includes a third sub-pattern and a fourth sub-pattern, and
   wherein a depth of the third sub-pattern in the first direction is different from a depth of the fourth sub-pattern in the first direction.
Clause 6: The semiconductor device of clause 5 when dependent on clause 4, wherein at least one of:
   the depth of the first sub-pattern in the first direction is smaller than the depth of the second sub-pattern in the first direction,
   the depth of the third sub-pattern in the first direction is smaller than the depth of the fourth sub-pattern in the first direction,
   the first sub-pattern and the third sub-pattern overlap in the first direction, and
   the second sub-pattern and the fourth sub-pattern overlap in the first direction.
Clause 7: The semiconductor device of any preceding clause, wherein each of the first dummy pattern and the second dummy pattern has at least one of a circular shape, a square shape, and a rod shape when viewed in a plan view.
Clause 8: The semiconductor device of any preceding clause, further comprising a source/drain contact on the source/drain pattern,
   wherein the via pattern is directly connected to the source/drain contact.
Clause 9: The semiconductor device of any preceding clause, wherein the via pattern extends through the lower pattern and is directly connected to the source/drain pattern.
Clause 10: The semiconductor device of any preceding clause, further comprising:
   a field insulating film on the first side of the first substrate, the field insulating film covering a side wall of the lower pattern; and
   a source/drain contact on the source/drain pattern,
   wherein the via pattern extends through the field insulation film, and
   wherein an upper side of the via pattern is coplanar with an upper side of the source/drain contact.
Clause 11: A semiconductor device comprising:
   a first substrate including a first side and a second side that are opposite to each other in a first direction;
   a lower pattern on the first side of the first substrate, the lower pattern extending in a second direction that intersects the first direction;
   a field insulating film on the first side of the first substrate and on a side wall of the lower pattern;
   a plurality of sheet patterns which are spaced apart from each other in the first direction on the lower pattern;
   a gate electrode surrounding portions of the plurality of sheet patterns on the first side of the first substrate, the gate electrode extending in a third direction;
   a source/drain pattern which is on one side of the gate electrode and connected to the plurality of sheet patterns;
   a power rail on the second side of the first substrate and extending in the second direction;
   a via pattern which extends through the first substrate and the field insulating film in the first direction, and is connected to each of the power rail and the source/drain pattern;
   a first insulating film on the first side of the first substrate;
   a first dummy pattern arranged in the first insulating film, the first dummy pattern including an insulating material that is a different material than a material included in the first insulating film;
   a second substrate which includes, on the first dummy pattern, a third side that faces the first side, and a fourth side that is opposite to the third side in the first direction;
   a second insulating film on the third side of the second substrate; and
   a second dummy pattern in the second insulating film and including an insulating material that is different from a material included in the second insulating film,
   wherein the first dummy pattern and the second dummy pattern are offset in the first direction.
Clause 12: The semiconductor device of clause 11, wherein the first dummy pattern and the second dummy pattern include the same material.
Clause 13: The semiconductor device of clause 11, wherein the first dummy pattern and the second dummy pattern include different materials from each other.
Clause 14: The semiconductor device of any of clauses 11 to 13, wherein the first dummy pattern includes a first sub-pattern and a second sub-pattern, and
   wherein a depth of the first sub-pattern in the first direction is smaller than a depth of the second sub-pattern in the first direction.
Clause 15: The semiconductor device of any of clauses 11 to 14, wherein the second dummy pattern includes a third sub-pattern and a fourth sub-pattern, and
   wherein a depth of the third sub-pattern in the first direction is smaller from a depth of the fourth sub-pattern in the first direction.
Clause 16: The semiconductor device of any of clauses 11 to 15, wherein a depth of the first dummy pattern in the first direction is smaller than a height of the first insulating film in the first direction.
Clause 17: The semiconductor device of any of clauses 11 to 16, wherein a depth of the second dummy pattern in the first direction is smaller than a height of the second insulating film in the first direction.
Clause 18: The semiconductor device of any of clauses 11 to 17, wherein the first insulating film and the second insulating film include the same material.
Clause 19: The semiconductor device of any of clauses 11 to 18, wherein the first insulating film includes the same material as the second dummy pattern, and
   wherein the second insulating film includes the same material as the first dummy pattern.
Clause 20: A semiconductor device comprising:
   a first substrate which includes a first side and a second side that are opposite to each other in a first direction;
   a plurality of lower patterns which extend in a second direction on the first side of the first substrate, and are spaced apart from each other in a third direction;
   a field insulating film on side walls of the plurality of lower patterns, and on the first side of the first substrate;
   a plurality of sheet patterns which are spaced apart from each other in the first direction, on the plurality of lower patterns;
   a plurality of gate electrodes which surround portions of the plurality of sheet patterns on the first side of the first substrate, extend in the third direction, and are spaced apart from each other in the second direction;
   a plurality of source/drain patterns which are between the plurality of gate electrodes, each of the plurality of source/drain patterns connected to at least one of the plurality of sheet patterns;
   a plurality of source/drain contacts which are on each of the plurality of source/drain patterns;
   a power rail which is on the second side of the first substrate and which extends in the second direction;
   a plurality of via patterns which extend through the first substrate and the field insulating film in the first direction, and are connected to each of the power rail and the plurality of source/drain patterns;
   a first insulating film on the first side of the first substrate;
   a first dummy pattern which extends through the first insulating film, and includes an insulating material that is different from a material included in the first insulating film;
   a first adhesive film which covers the first insulating film and the first dummy pattern;
   a second substrate which includes, on the first dummy pattern, a third side that faces the first side, and a fourth side opposite to the third side in the first direction;
   a second insulating film on the third side of the second substrate;
   a second dummy pattern which extends through the second insulating film, and includes an insulating material that is a different material from a material included in the second insulating film; and
   a second adhesive film which covers the second insulating film and the second dummy pattern,
   wherein the first adhesive film is bonded to the second adhesive film,
   wherein each of the first dummy pattern and the second dummy pattern has at least one of a circular shape, a quadrangular shape, and a bar shape when viewed in a plan view,
   wherein the first dummy pattern and the second dummy pattern overlap each other in the first direction,
   wherein the first insulating film and the second insulating film include the same material, and
   wherein the first dummy pattern and the second dummy pattern include the same material.

## Claims

1. A semiconductor device comprising:
a first substrate which includes a first side and a second side that are opposite from each other in a first direction;
a lower pattern on the first side of the first substrate, the lower pattern extending in a second direction that intersects the first direction;
a plurality of sheet patterns which are spaced apart from each other in the first direction on the lower pattern;
a gate electrode surrounding portions of the plurality of sheet patterns on the first side of the first substrate, the gate electrode extending in a third direction that intersects the first direction and the second direction;
a source/drain pattern which is on a first side of the gate electrode and connected to the plurality of sheet patterns;
a power rail which is on the second side of the first substrate and which extends in the second direction;
a via pattern which extends through the first substrate in the first direction, the via pattern connected to the power rail and to the source/drain pattern;
a first dummy pattern that includes an insulating material on the via pattern;
a second substrate which includes, on the first dummy pattern, a third side that faces the first side, and a fourth side opposite from the third side in the first direction; and
a second dummy pattern on the third side of the second substrate, the second dummy pattern including an insulating material,
wherein the first dummy pattern and the second dummy pattern overlap each other in the first direction.

2. The semiconductor device of claim 1, wherein the first dummy pattern and the second dummy pattern include the same material.

3. The semiconductor device of claim 1, wherein the first dummy pattern and the second dummy pattern include different materials from each other.

4. The semiconductor device of any preceding claim, wherein the first dummy pattern includes a first sub-pattern and a second sub-pattern, and
wherein a depth of the first sub-pattern in the first direction is different from a depth of the second sub-pattern in the first direction.

5. The semiconductor device of claim 4, wherein the second dummy pattern includes a third sub-pattern and a fourth sub-pattern, and
wherein a depth of the third sub-pattern in the first direction is different from a depth of the fourth sub-pattern in the first direction.

6. The semiconductor device of claim 5, wherein the depth of the first sub-pattern in the first direction is smaller than the depth of the second sub-pattern in the first direction,
wherein the depth of the third sub-pattern in the first direction is smaller than the depth of the fourth sub-pattern in the first direction,
wherein the first sub-pattern and the third sub-pattern overlap in the first direction, and
wherein the second sub-pattern and the fourth sub-pattern overlap in the first direction.

7. The semiconductor device of any preceding claim, wherein each of the first dummy pattern and the second dummy pattern has at least one of a circular shape, a square shape, and a rod shape when viewed in a plan view.

8. The semiconductor device of any preceding claim, further comprising:
a field insulating film on the first side of the first substrate, the field insulating film covering a side wall of the lower pattern; and
a source/drain contact on the source/drain pattern,
wherein the via pattern extends through the field insulation film, and
wherein an upper side of the via pattern is coplanar with an upper side of the source/drain contact.

9. A semiconductor device comprising:
a first substrate including a first side and a second side that are opposite to each other in a first direction;
a lower pattern on the first side of the first substrate, the lower pattern extending in a second direction that intersects the first direction;
a field insulating film on the first side of the first substrate and on a side wall of the lower pattern;
a plurality of sheet patterns which are spaced apart from each other in the first direction on the lower pattern;
a gate electrode surrounding portions of the plurality of sheet patterns on the first side of the first substrate, the gate electrode extending in a third direction;
a source/drain pattern which is on one side of the gate electrode and connected to the plurality of sheet patterns;
a power rail on the second side of the first substrate and extending in the second direction;
a via pattern which extends through the first substrate and the field insulating film in the first direction, and is connected to each of the power rail and the source/drain pattern;
a first insulating film on the first side of the first substrate;
a first dummy pattern arranged in the first insulating film, the first dummy pattern including an insulating material that is a different material than a material included in the first insulating film;
a second substrate which includes, on the first dummy pattern, a third side that faces the first side, and a fourth side that is opposite to the third side in the first direction;
a second insulating film on the third side of the second substrate; and
a second dummy pattern in the second insulating film and including an insulating material that is different from a material included in the second insulating film,
wherein the first dummy pattern and the second dummy pattern are offset in the first direction.

10. The semiconductor device of claim 9, wherein the first dummy pattern and the second dummy pattern include the same material.

11. The semiconductor device of claim 9 or 10, wherein the first dummy pattern includes a first sub-pattern and a second sub-pattern, and
wherein a depth of the first sub-pattern in the first direction is smaller than a depth of the second sub-pattern in the first direction.

12. The semiconductor device of any of claims 9 to 11, wherein the second dummy pattern includes a third sub-pattern and a fourth sub-pattern, and
wherein a depth of the third sub-pattern in the first direction is smaller from a depth of the fourth sub-pattern in the first direction.

13. The semiconductor device of any of claims 9 to 12, wherein a depth of the first dummy pattern in the first direction is smaller than a height of the first insulating film in the first direction.

14. The semiconductor device of any of claims 9 to 13, wherein the first insulating film includes the same material as the second dummy pattern, and
wherein the second insulating film includes the same material as the first dummy pattern.

15. A semiconductor device comprising:
a first substrate which includes a first side and a second side that are opposite to each other in a first direction;
a plurality of lower patterns which extend in a second direction on the first side of the first substrate, and are spaced apart from each other in a third direction;
a field insulating film on side walls of the plurality of lower patterns, and on the first side of the first substrate;
a plurality of sheet patterns which are spaced apart from each other in the first direction, on the plurality of lower patterns;
a plurality of gate electrodes which surround portions of the plurality of sheet patterns on the first side of the first substrate, extend in the third direction, and are spaced apart from each other in the second direction;
a plurality of source/drain patterns which are between the plurality of gate electrodes, each of the plurality of source/drain patterns connected to at least one of the plurality of sheet patterns;
a plurality of source/drain contacts which are on each of the plurality of source/drain patterns;
a power rail which is on the second side of the first substrate and which extends in the second direction;
a plurality of via patterns which extend through the first substrate and the field insulating film in the first direction, and are connected to each of the power rail and the plurality of source/drain patterns;
a first insulating film on the first side of the first substrate;
a first dummy pattern which extends through the first insulating film, and includes an insulating material that is different from a material included in the first insulating film;
a first adhesive film which covers the first insulating film and the first dummy pattern;
a second substrate which includes, on the first dummy pattern, a third side that faces the first side, and a fourth side opposite to the third side in the first direction;
a second insulating film on the third side of the second substrate;
a second dummy pattern which extends through the second insulating film, and includes an insulating material that is a different material from a material included in the second insulating film; and
a second adhesive film which covers the second insulating film and the second dummy pattern,
wherein the first adhesive film is bonded to the second adhesive film,
wherein each of the first dummy pattern and the second dummy pattern has at least one of a circular shape, a quadrangular shape, and a bar shape when viewed in a plan view,
wherein the first dummy pattern and the second dummy pattern overlap each other in the first direction,
wherein the first insulating film and the second insulating film include the same material, and
wherein the first dummy pattern and the second dummy pattern include the same material.
